# EUROPÄISCHE PATENTSCHRIFT

(11) **EP 1 878 484 B1**
(45) Veröffentlichungstag und Bekanntmachung des Hinweises auf die Patenterteilung: **02.12.2009**
(21) Anmeldenummer: 07012447.4
(22) Anmeldetag: 26.06.2007
(51) Int. Cl.: B01D 46/42, F04D 25/02, F04D 29/70, F24F 13/28, H05K 7/20

(54) **Luftdurchtrittsvorrichtung**
Air passing device
Dispositif de passage d'air

(30) Priorität: 13.07.2006 DE 202006010888 U; 01.11.2006 DE 202006016841 U
(43) Veröffentlichungstag der Anmeldung: 16.01.2008
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- DE-A1- 19 700 065
- DE-U1- 20 308 482
- DE-U1- 29 505 447
- DE-U1-202004 006 784
- GB-A- 2 149 686
- US-A- 2 575 499

## Beschreibung

Die Erfindung betrifft eine Luftdurchtrittsvorrichtung, insbesondere Filterlüfter oder Austrittsfilter gemäß dem Oberbegriff des Anspruches 1.

Bei in einem Gehäuse angeordneten Bauteilen, welche entsprechende Abwärme erzeugen, ist es notwendig, die Abwärme aus dem Gehäuse abzuführen und eine Temperatur in dem Gehäuse durch mehr oder weniger starkes Einblasen oder Absaugen von Umgebungsluft in den Gehäuseinnenraum mittels des Lüfters zu kontrollieren. Ein bekanntes Beispiel hierfür sind Computergehäuse. Üblicherweise werden derartige Gehäuse mit einem Filterlüfter versehen, welcher entweder ständig läuft oder von einer Steuerung in Abhängigkeit von einer Temperatur im Gehäuse an- und abgeschaltet wird. Der Filterlüfter ist in einer Ausnehmung einer Wand des Gehäuses angeordnet und beispielsweise mittels Schraubverbindungen fixiert. Gleichzeitig sind an einer anderen Stelle des Gehäuses für einen Luftaustritt entsprechende Luftaustrittsschlitze vorgesehen. Die Montage derartiger Filterlüfter ist jedoch oftmals mühevoll, da bei der Anwendung von Schraubverbindungen kaum Spielraum zur Verfügung steht, um den Filterlüfter auch noch nachträglich optisch ausrichten zu können.

Die bei diesen Filterlüftern verwendeten Filtermatten sind zwischen dem äußeren Lüftergitter und dem Grundgehäuse angeordnet. Das Lüftergitter ist vermittels Klemm- oder Rastverbindungen oder Schraubverbindungen mit dem Grundgehäuse lösbar verbunden. Soll eine gebrauchte Filtermatte gegen eine neue Filtermatte ausgewechselt werden, so muss das gesamte Lüftergitter von dem Grundgehäuse abgenommen werden, wobei die Verbindungsmittel in den meisten Fällen mittels Werkzeuge gelöst werden müssen.

Durch die DE 100 51 643 A1 ist ein Filterlüftergehäuse mit einem bodenseitigen Lufteintritt und einem Luftaustritt, der im rechten Winkel zum Lufteintritt steht, wobei die Luftaustrittsöffnung mit dem Innenraum eines Schaltschrankes in Verbindung steht, bekannt. Im Innenraum des Gehäuses ist eine Filtermatte angeordnet, die eine Schrägstellung einnimmt, so dass der Luftstrom vom Lufteintritt zum Luftaustritt durch die Filtermatte geführt ist. Der Innenraum des Filtermattengehäuses ist über eine verschließbare Wartungsöffnung zugänglich, um einen Filtermattenwechsel vornehmen zu können.

Die DE 40 13 645 A1 offenbart einen Luftfilter für ein Elektronikgehäuse, der derart ausgebildet ist, dass ein Auswechseln der Filtermatten ohne Betriebsunterbrechung des Gerätes möglich sein soll. Hierzu weist der Luftfilter eine Filtermatte, mittels derer Staub und Verunreinigungen aus einem von außerhalb angesaugten Luftstrom entfernbar ist, und einen Träger auf, in welchem die Filtermatte angebracht ist und der einen Halterahmen sowie einen Griff zum Handhaben des Trägers umfasst. Des weiteren sind Halteeinrichtungen zum einrastenden Halten des Trägers in/an dem Gehäuse in dichtem Abschluss vor Lüftungsöffnungen des Gehäuses und Führungseinrichtungen vorgesehen, die derart an dem Gehäuse angebracht sind, dass der Träger durch eine Einschuböffnung im Gehäuse entlang der Führungseinrichtungen zu den Halteeinrichtungen und wieder hinaus bewegbar und in die Halteeinrichtungen einrastbar ist.

Zum einen setzt der Filterlüfter ein speziell ausgebildetes Gehäuse auf, damit der Luftstrom in einem Winkel vom Einlass zum Auslass durch den Innenraum des Gehäuses geleitet werden kann, das eine gesonderte, verschließbare Wartungsöffnung aufweist, um die Filtermatte durch die Wartungsöffnung zum Auswechseln ergreifen zu können, während zum anderen das Luftfiltergehäuse mit einer Wartungsöffnung versehen ist, um über diese die kassettenartig ausgebildete Filtermatte auswechseln zu können.

Die DE 20 2004 006 784 U1, die als nächstliegender Stand der Technik angesehen wird, offenbart einen Filterlüfter oder Austrittsfilter für den Einbau in eine Montagedurchbrechung in einer Montagewand mit einem Grundgehäuse, mit einem umlaufenden Rahmen aus Seitenwänden und einem Designdeckel mit einem luftaustrittsseitig angeformten, umlaufenden Rahmen aus Seitenwänden. Lufteintrittsseitig weist der Designdeckel ein Lüftungsgitter zum Einlass zu filternder Luft auf. Zwischen Designdeckel und Grundgehäuse ist eine Filtermatte aufnehmbar, die durch eine Entnahmeöffnung in diesen Aufnahmebereich eingeführt werden kann. Der Designdeckel ist um eine waagerechte Schwenkachse in seinem unteren Randbereich schwenkbar am Grundgehäuse gelagert. Daher kann ein Benutzer, um beispielsweise eine verschmutzte Filtermatte auszutauschen, die Entnahmeöffnung 29 öffnen, in dem er den Designdeckel um die Schwenkachse vom Grundgehäuse wegschwenkt. Vorteilhaft ist hierbei, dass der Designdeckel stets mit dem Grundgehäuse verbunden bleibt. Es hat sich jedoch gezeigt, dass bei dieser Vorrichtung das Lösen des Designdeckels vom Grundgehäuse bzw. das sichere Verschließen bzw. Lagern des Designdeckels am Grundgehäuse teilweise schwierig und unkomfortabel für Benutzer sind.

Die US 2,575,499 A offenbart eine Filtereinrichtung für Klimaanlagen mit einem Gehäuse zum Einsatz einer Filtermatte und einem zum Verschluss des Gehäuses ausgebildeten und in seinem unteren Randbereich schwenkbar an diesem gelagerten Lüftungsgitter. Zum Halten des Lüftungsgitters im Gehäuse ist an einem Randbereich des Lüftungsgitters eine Nocke und an einem inneren Randbereich des Gehäuses eine mit der Nocke korrespondierende Vertiefung vorgesehen. Ferner ist im oberen Randbereich des Lüftungsgitters, der der Schwenkachse gegenüberliegend angeordnet ist, ein Verriegelungshebel zur Sicherung des Lüftungsgitters im Gehäuse vorgesehen. Somit ist auch hier die Ausbildung der Halterung des Lüftungsgitters im Gehäuse relativ unbequem in der Bedienung für einen Benutzer und relativ aufwendig in der Herstellung.

Aufgabe der vorliegenden Erfindung ist es, eine Luftdurchtrittsvorrichtung gemäß der eingangs beschriebenen Art so auszubilden, dass die Entnahmeöffnung für die Filtermatte möglichst einfach und leicht handhabbar aufgebaut, bzw. ein Wechsel der Filtermatten ohne großen konstruktiven Aufwand und ein müheloses Öffnen des Lüftergitters vermittels Fingerdruck möglich ist.

Gelöst wird diese Aufgabe bei einer Luftdurchtrittsvorrichtung mit den im Anspruch 1 angegebenen Merkmalen.

Hiernach besteht die Erfindung darin, dass mindestens ein verschwenkbares Lamellenelement oder durch quer zur Seitenwandlängsrichtung verlaufende Schlitze von der übrigen Seitenwandfläche getrennt mindestens ein federnder, zungenförmiger Seitenwandabschnitt im Bereich der der Schwenkachse zum Verschwenken des Designdeckels abgekehrten oberen Seitenwand des Designdeckels oder im Bereich der der Schwenkachse zum Verschwenken des Designdeckels abgekehrten oberen Seitenwand des Rahmens des Grundgehäuses ausgebildet ist, wobei das Lamellenelement und der zungenförmige Seitenwandabschnitt als fingerbetätigbare lösbare und verriegelbare Rastverbindung zwischen dem Designdeckel und dem Grundgehäuse ausgebildet ist.

Eine erste Ausführungsform der Erfindung besteht darin, dass mindestens ein Lamellenelement, bevorzugter Weise das oberste Lamellenelement, oder ein Abschnitt des Lamellenelementes oder nur mit der oberen Seitenwand des Designdeckels mit seiner Längskante verbundenes Lamellenelement des Lüftergitters um eine in Längsrichtung des Lamellenelementes verlaufende Drehachse in dem Lüftergitter verschwenkbar angeordnet und als fingerbetätigbares Betätigungselement für eine Arretierungseinrichtung zum Verriegeln und Lösen einer Verriegelung zwischen dem Lüftergitter und dem Grundgehäuse ausgebildet ist.

Dadurch, dass der Designdeckel mit dem Lüftergitter zusammen mit der Filtermatte schwenkbar an dem Grundgehäuse der Luftdurchtrittsvorrichtung gehalten ist, ist ein Auswechseln der Filtermatten mühelos vornehmbar, denn der Designdeckel wird einfach aufgeklappt und verschwenkt, so dass die Filtermatte für ein Auswechseln frei zugänglich ist. Durch das Öffnen des Designdeckels wird die Wartungsöffnung für das Auswechseln der Filtermatte geschaffen, wodurch die Ausbildung einer gesonderten Wartungsöffnung in dem Lüftergehäuse entfällt.

Ein weiterer Vorteil besteht darin, dass das Öffnen und Schließen des Designdeckels vermittels eines Lamellenelementes des Lüftergitters oder einer Seitenwand des Designdeckels erfolgt. Das Lamellenelement ist somit als finterbetätigbares Betätigungselement für die Einrichtung zum Verriegeln und Lösen einer Verriegelung zwischen dem Designdeckel bzw. dem Lüftergitter und dem Grundgehäuse ausgebildet.

Um das besagte Lamellenelement betätigen zu können, ist dieses nach einer Ausführungsform bevorzugter Weise um seine Längsachse verschwenkbar in den Seitenwänden des Designdeckels bzw. Lüftergitters gehalten. Alternativ kann das Lamellenelement seitlich unterbrochen sein, wobei dann als Schwenkscharnier die Längsachse im Bereich der Verbindung zum Grundgehäuse dient, wenn dieses Lamellenelement an dem Grundgehäuse angeformt ist, wobei dieser Verbindungsbereich auch als Filmscharnier ausgebildet sein kann, jedoch reicht die Verwendung eines biegeelastischen Materials, wie Kunststoff, aus, um ein Verschwenken des Lamellenelementes zu ermöglichen.

Dieses bedienbare Lamellenelement des Lüftergitters weist im Bereich seiner dem Grundgehäuse zugekehrten und der bodenseitigen Schwenkachse des Lüftergitters abgekehrten Längskante einen Rastnocken auf, der zur Ausbildung einer Rastverbindung in Wirkverbindung mit einem beispielsweise hakenförmigen oder ausnehmungsartigen Rastelement in Wirkverbindung bringbar ist. Beim Schließen des Designdeckels bzw. des Lüftergitters rasten die Elemente der Verschlusseinrichtung gegeneinander ein, so dass die Filtermatte zwischen dem Lüftergitter und dem Grundgehäuse sicher gehalten ist.

Die Ausgestaltung der Rastverbindung ist nicht ausschließlich auf die obere Längskante des verschwenkbaren Lamellenelementes begrenzt. Die einzelnen Elemente für die Rastverbindung können sowohl an der Längskante des verschwenkbaren Lamellenelementes mittig oder außermittig angeordnet sein, wobei im letzteren Fall dann eine oder mehrere Rastverbindungen vorgesehen sein können, die so ausgebildet und angeordnet sind, dass die Rastverbindungen im Bereich der seitlichen Wandflächen des Designdeckels ausgebildet sind.

Eine weitere Ausgestaltung der Erfindung sieht vor, dass in der die dem obersten Lamellenelement des Lüftergitters zugekehrten Seitenwand durch quer zur Seitenwandlängsrichtung verlaufende Schlitze ein Wandabschnitt ausgebildet ist, an dem mit seiner Längskante ein in den sich gegenüberliegenden Seitenwänden des Designdeckels unverbundenes Lamellenelement angeformt ist, wobei im Bereich der Anformung des Lamellenelementes an dem Seitenwandabschnitt der Seitenwand des Designdeckels die Längsachse LA für das Verschwenken des Seitenwandabschnittes bei Fingerbetätigung des Lamellenelementes liegt. Auch bei dieser Ausführungsform bildet der Verbindungsbereich zwischen der Seitenwand und dem Lamellenelement die Schwenkachse für den Seitenwandabschnitt, um diesen Verschwenken zu können.

Es ist somit ein werkzeugfreies Wechseln der Filtermatte möglich, so dass auch im eingebauten Zustand der Luftdurchtrittsvorrichtung die Filtermatten gewechselt werden können. Durch außenseitige Betätigung des verschwenkbaren Lamellenelementes ist ein müheloses Öffnen des Designdeckels zur Freigabe der Filtermatte zur Entnahme möglich. Nach dem Auswechseln der Filtermatte wird lediglich der Designdeckel gegen das Grundgehäuse der Luftdurchtrittsvorrichtung geschwenkt, so dass die Rastverbindung hergestellt und der Aufnahmeraum für die Filtermatte geschlossen ist.

Eine zweite Ausführungsform der Erfindung besteht darin, dass in der der Schwenkachse zum Verschwenken des Designdeckels abgekehrten Seitenwand des Designdeckels durch quer zur Seitenwandlängsrichtung verlaufende Schlitze von der übrigen Seitenwandfläche getrennt mindestens ein federnder, zungenförmiger Seitenwandabschnitt ausgebildet ist, der federnd-elastisch ist und ein Rückstellvermögen aufgrund des Materials, aus dem der Designdeckel besteht, aufweist, wobei der zungenförmige Seitenwandabschnitt vermittels eines Steges in der Seitenwand gehalten ist und im Bereich seines freien Endes zur Herstellung einer lösbaren Rastverbindung zwischen dem Designdeckel und dem Grundgehäuse ein Eingriffelement aufweist, das mit einem Halteelement in Wirkverbindung bringbar ist, das an der Seitenwand des Grundgehäuses angebracht oder angeformt ist, die mit der Seitenwand des Designdeckels korrespondiert.

Auch mit dieser Ausführungsform der Erfindung wird erreicht, dass der Designdeckel mit dem Lüftergitter zusammen mit der Filtermatte schwenkbar an dem Grundgehäuse der Luftdurchtrittsvorrichtung gehalten ist, so dass ein Auswechseln der Filtermatten mühelos vorgenommen werden kann, denn der Designdeckel wird einfach aufgeklappt und verschwenkt, so dass die Filtermatte für ein Auswechseln frei zugänglich ist. Durch das Öffnen des Designdeckels wird die Wartungsöffnung für das Auswechseln der Filtermatte geschaffen, wodurch die Ausbildung einer gesonderten Wartungsöffnung in dem Lüftergehäuse entfällt.

Ein weiterer Vorteil besteht darin, dass das Öffnen und Schließen des Designdeckels dadurch vereinfacht wird, dass die der Schwenkachse des Designdeckels abgewandte Seitenwand des Designdeckels mindestens einen aus dem Seitenwandmaterial gebildeten federnd-elastischen zungenförmigen Abschnitt aufweist, der mit einem Eingriffelement versehen ist, das beim Schließen des Designdeckels in ein Halteelement eingreift, das an der mit der, den zungenförmigen Seitenwandabschnitt aufweisenden Seitenwand des Designdeckels korrespondierenden Seitenwand des Grundgehäuses angeformt oder ausgebildet ist, so dass beim Schließen des Designdeckels das Eingriffelement des zungenförmigen Seitenwandabschnittes in das Halteelement eingreift oder einrastet. Bei diesem Vorgang federt der abgebogene zungenförmige Seitenwandabschnitt in seine Ausgangsposition zurück, so dass der Designdeckel mit dem Grundgehäuse verriegelt wird. Für die Entriegelung wird der Designdeckel von dem Grundgehäuse abgezogen, wobei sich die Rastverbindung löst.

Es ist somit ebenfalls ein werkzeugfreies Wechseln der Filtermatten möglich, so dass auch im eingebauten Zustand der Luftdurchtrittsvorrichtung die Filtermatten gewechselt werden können. Durch außenseitige Betätigung des federnd-elastisch ausgebildeten Abschnittes in der oberen Seitenwand des Designdeckels ist ein müheloses Öffnen des Designdeckels zur Freigabe der Filtermatte zur Entnahme möglich. Nach dem Auswechseln der Filtermatte wird lediglich der Designdeckel gegen das Grundgehäuse der Luftdurchtrittsvorrichtung geschwenkt, so dass die Rastverbindung hergestellt und der Aufnahmeraum für die Filtermatte geschlossen ist.

Eine weitere Ausführungsform der Erfindung sieht vor, dass zur Herstellung der lösbaren Rastverbindung zwischen dem Designdeckel und dem Grundgehäuse mindestens eine der Seitenwände des Rahmens des Designdeckels mindestens einen aus dem Material der Seitenwand ausgebildeten, federnden, zungenförmigen Seitenwandabschnitt aufweist, der einendseitig über einen Steg mit der Seitenwand verbunden und in dieser gehalten ist und die an ihrem freien Ende einen Rastnocken als Eingriffelement aufweist, der mit einem Halteelement in Wirkverbindung bringbar ist, das in der Seitenwand des Grundgehäuses vorgesehen ist, die mit der Seitenwand des Designdeckels korrespondiert.

Dabei ist der federnde, zungenförmige Seitenwandabschnitt durch zwei quer zur Längsrichtung der Seitenwand des Rahmens des Designdeckels verlaufende Längsschlitze ausgebildet, deren Länge kleiner ist als die Breite der Seitenwand.

In den oberen Bereichen bzw. in den Seitenwänden des Designdeckels und/oder des Grundgehäuses sind mindestens ein zungenförmiger Seitenwandabschnitt und mindestens ein mit dem zungenförmigen Seitenwandabschnitt korrespondierendes Halteelement in den jeweiligen Seitenwänden der Rahmen des Designdeckels und des Grundgehäuses vorgesehen.

Bevorzugter Weise sind der zungenförmige Seitenwandabschnitt und das mit diesem korrespondierende Halteelement mittig an den Seitenwänden der Rahmen des Designdeckels und des Grundgehäuses angeordnet.

Nach einer weiteren Ausführungsform der Erfindung sind in den oberen Bereichen bzw. den miteinander korrespondierenden Seitenwänden des Designdeckels und des Grundgehäuses zwei zungenförmige Seitenwandabschnitte und zwei mit den zungenförmigen Seitenwandabschnitten korrespondierende Halteelemente in den jeweiligen Seitenwänden der Rahmen des Designdeckels und des Grundgehäuses vorgesehen.

Des weiteren weist jeder zungenförmige Seitenwandabschnitt an seinem freien Ende einen im rechten Winkel abgebogenen Abschnitt auf, der in eine entsprechend ausgebildete schlitzförmige Ausnehmung oder Durchbrechung in der korrespondierenden Seitenwand des Rahmens des Grundgehäuses als Halteelement eingreift bzw. hintergreift.

Eine weitere Ausführungsform sieht eine Luftdurchtrittsvorrichtung vor, bei der jeder zungenförmige Seitenwandabschnitt des Designdeckels im Bereich seines freien Endes einen Rastnocken aufweist, wobei an der Unterseite der die Seitenwand des Designdeckels übergreifenden Seitenwand des Grundgehäuses eine entsprechend der Formgebung des Rastnockens entsprechend gestaltete Vertiefung vorgesehen ist.

Eine derart ausgebildete Rastverbindung erbringt den Vorteil, dass das Öffnen und Schließen des Designdeckels dadurch vereinfacht wird, dass die der Schwenkachse des Designdeckels abgewandte Seitenwand des Designdeckels mindestens einen aus dem Seitenwandmaterial gebildeten federnd-elastischen zungenförmigen Abschnitt aufweist, der einen Rastnocken aufweist, der beim Schließen des Designdeckels in eine Ausnehmung bzw. Vertiefung eingreift, die an der Unterseite der mit der, den zungenförmigen Abschnitt aufweisenden Seitenwand des Designdeckels korrespondierenden Seitenwand des Grundgehäuses ausgebildet ist, so dass beim Schließen des Designdeckels der zungenförmige Seitenwandabschnitt abgebogen wird, bis der Rastnocken in die Vertiefung an der Seitenwand des Grundgehäuses einrastet, wobei dann der zungenförmige Abschnitt in seine Ausgangsposition zurückfedert, bis der Rastnocken vollständig in die Vertiefung eingerastet ist, so dass der Designdeckel mit dem Grundgehäuse verriegelt wird. Für die Entriegelung wird der zungenförmige Seitenwandabschnitt z. B. durch Beaufschlagung mit einem spitzen Gegenstand nach unten abgebogen, so dass der Designdeckel von dem Grundgehäuse abgezogen wird, wobei sich der Rastnocken des Grundgehäuses aus der Vertiefung an der Seitenwand des Grundgehäuses herausbewegt, wobei aufgrund der federnd-elastischen Ausbildung des zungenförmigen Seitenwandabschnittes dieser an der Seitenwand des Grundgehäuses geringfügig abgebogen wird, so dass der Rastnocken aus der Vertiefung gleiten kann.

Des Weiteren ist vorgesehen, dass der Designdeckel an jeder beliebigen Seitenwand des Rahmens des Grundgehäuses verschwenkbar angeordnet ist, wobei die Rastverbindung für den Designdeckel und dem Grundgehäuse an dem der Schwenkachse für den Designdeckel gegenüberliegenden Seitenwänden des Designdeckels und dem Grundgehäuse vorgesehen ist.

Eine weitere Ausführungsform sieht vor, dass zur Herstellung der lösbaren Rastverbindung zwischen dem Designdeckel und dem Grundgehäuse in mindestens einer der Seitenwände des Rahmens des Grundgehäuses mindestens ein aus dem Material der Seitenwand durch quer zur Seitenwandlängsrichtung verlaufende Schlitze von der übrigen Seitenwandfläche getrennter federnder zungenförmiger Seitenwandabschnitt ausgebildet ist, wobei der zungenförmige Seitenwandabschnitt vermittels eines Steges in der Seitenwand gehalten ist und innenwandseitig ein Halteelement in Form einer bevorzugter Weise kreisrunden Vertiefung oder Durchbrechung, Bohrung oder Sacklochbohrung aufweist, die mit einem Eingriffelement in Form eines Rastnockens in Wirkverbindung bringbar ist, das an der mit der das Halteelement aufweisenden Seitenwand des Grundgehäuses korrespondierenden Seitenwand des Designdeckels angeordnet oder angeformt ist, wobei der Rastnocken bevorzugter Weise an seinem freien Ende mit einem abschnittsweise ausgebildeten oder umlaufenden konisch zum Rastnockenende verlaufenden Abschnitt als Gleitfläche versehen ist.

Somit besteht die Erfindung in einem Verbindungssystem, für den Designdeckel und das Grundgehäuse der Luftdurchtrittsverbindung, das per Fingerdruck zum Öffnen des Designdeckels für einen Filtermattenwechsel gelöst werden kann und das so ausgebildet ist, dass beim Schließen des Designdeckels dieser in das Grundgehäuse einrastet.

Weitere vorteilhafte Ausgestaltungen der Erfindung sind Gegenstand der Unteransprüche.

Ausführungsbeispiele der Erfindung sind in den Zeichnungen dargestellt.
Es zeigen:
- Fig. 1: eine schaubildliche Explosionsdarstellung der Luftdurchtrittsvorrichtung nach einer ersten Ausführungsform der Erfindung, bestehend aus einem vorderen Designdeckel mit einem Lüftergitter und mit einer Filtermatte, einem Grundgehäuse für den Designdeckel und für einen Ventilator und mit einem als fingerbetätigbares Betätigungselement für eine Arretierungseinrichtung zum Verriegeln und Lösen einer rastartigen Verriegelung zwischen dem Lüftergitter bzw. Designdeckel und dem Grundgehäuse der Luftdurchtrittsvorrichtung ausgebildetem Lamellenelement,
- Fig. 2: eine schaubildliche Darstellung des Grundgehäuses mit aufgeklapptem Designdeckel und mit einer zwischen dem Grundgehäuse und dem Designdeckel liegenden Filtermatte der Luftdruchtrittsvorrichtung gemäß Fig. 1,
- Fig. 3: einen senkrechten Schnitt durch die Luftdurchtrittsvorrichtung,
- Fig. 4: in einer Vorderansicht das Lüftergitter des Designdeckels mit Lamellenelementen,
- Fig. 5: eine schaubildliche Rückansicht des Designdeckels mit dem Lüftergitter,
- Fig. 6: einen Abschnitt des Lüftergitters des Designdeckels mit einem als Bedienungselement ausgebildeten Lamellenelement in einer vergrößerten schaubildlichen Darstellung,
- Fig. 7: in einer schaubildlichen Ansicht das als Bedienungselement ausgebildete, verschwenkbare Lamellenelement mit der Arretierungsvorrichtung für die lösbare Befestigung des Designdeckels an dem Grundgehäuse der Luftdurchtrittsvorrichtung,
- Fig. 8: eine Rückansicht des Designdeckels mit einer als Bedienungselement für die Arretierungsvorrichtung ausgebildeten Seitenwand,
- Fig. 9: eine vergrößerte Ansicht von oben auf den Designdeckel mit der als Bedienungselement ausgebildeten Seitenwand,

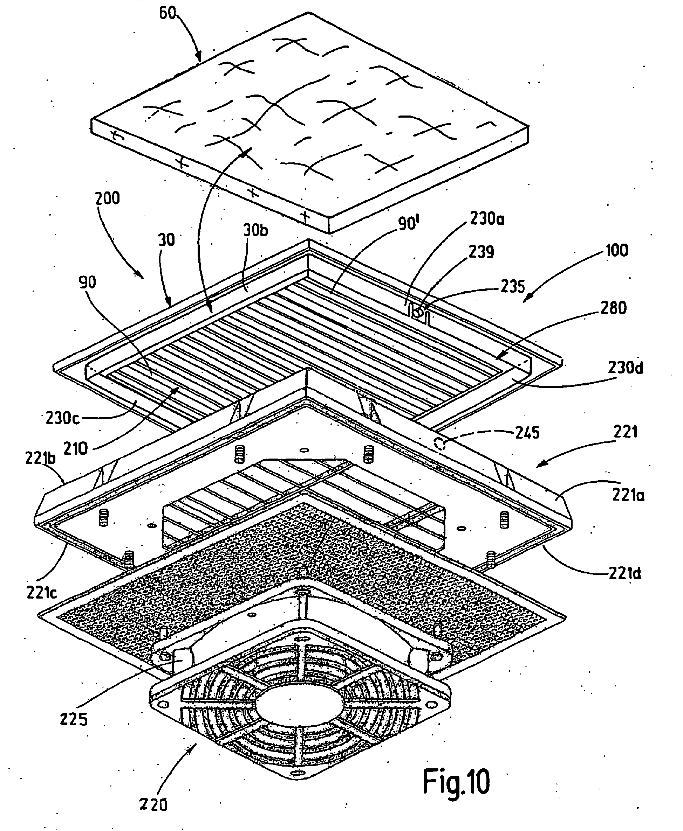

- Fig. 10: eine schaubildliche Explosionsdarstellung der Luftdurchtrittsvorrichtung nach einer zweiten Ausführungsform der Erfindung, bestehend aus einem Designdeckel mit einem Lüftergitter und mit einer Filtermatte und einem Grundgehäuse für den Designdeckel für einen Ventilator und mit einem als fingerbetätigbares Betätigungselement für eine Arretierungseinrichtung zum Verriegeln und Lösen einer rastartigen Verriegelung zwischen dem Lüftergitter bzw. Designdeckel und dem Grundgehäuse der Luftdurchtrittsvorrichtung ausgebildeter, federnder und zungenförmiger Seitenwandabschnitt des Designdeckels,
- Fig. 11: eine schaubildliche Darstellung des Grundgehäuses mit aufgeklapptem Designdeckel und mit einer zwischen dem Grundgehäuse und dem Designdeckel angeordneten Filtermatte der Luftdurchtrittsvorrichtung gemäß Fig. 10,
- Fig. 12: eine Vorderansicht der Luftdurchtrittsvorrichtung,
- Fig. 13: einen senkrechten Schnitt durch die Luftdurchtrittsvorrichtung,
- Fig. 14: eine schaubildliche Rückansicht des Designdeckels mit einem federnden, zungenförmigen Seitenwandabschnitt in der oberen Seitenwand des Rahmens des Designdeckels als Bedienungselement für die Herstellung einer Rastverbindung zwischen dem Designdeckel und dem Grundgehäuse der Luftdurchtrittsvorrichtung, wobei der zungenförmige Seitenwandabschnitt an seinem freien Ende ein Eingriffselement in Form eines Rastnockens aufweist,
- Fig. 15: eine vergrößerte Ansicht von oben auf den Designdeckel mit dem in der oberen Seitenwand des Designdeckels ausgebildeten zungenförmigen, den Rastnocken aufweisenden Seitenwandabschnitt,
- Fig. 16: eine vergrößerte Ansicht von oben auf das Grundgehäuse mit dem auf der Unterseite der oberen Seitenwand ausgebildeten Halteelement in Form einer Vertiefung für den Eingriff des Rastnockens an dem zungenförmigen Seitenwandabschnitt,
- Fig. 17: eine vergrößerte schematische Seitenansicht eines Abschnittes des Designdeckels mit dem federnden, zungenförmigen Seitenwandabschnitt, der an seinem freien Ende den Rastnocken trägt, der in die Vertiefung an der Unterseite der Seitenwand des Grundgehäuses eingreift,
- Fig. 18: eine vergrößerte schematische Seitenansicht eines Abschnittes des Grundgehäuses mit der in der Seitenwand des Grundgehäuses ausgebildeten Vertiefung zur Aufnahme des Rastnockens,
- Fig. 19: eine vergrößerte Ansicht von oben auf den Designdeckel mit zwei in der oberen Seitenwand des Designdeckels ausgebildeten mit an ihren Enden tragenden Eingriffelementen in Form von Rastnocken für die Herstellung der Rastverbindung zwischen dem Designdeckel und dem Grundgehäuse der Luftdurchtrittsvorrichtung,
- Fig. 20: eine vergrößerte Ansicht von oben auf das Grundgehäuse mit zwei in der oberen Seitenwand des Grundgehäuses vorgesehenen Halteelementen in Form von schlitzförmigen Durchbrechungen für den Eingriff der Eingriffelemente an den zungenförmigen Seitenwandabschnitten des Designdeckels,
- Fig. 21: eine schaubildliche Rückansicht auf das Grundgehäuse der Luftdurchtrittsvorrichtung,
- Fig. 22: eine schaubildliche Ansicht auf das Grundgehäuse der Luftdurchtrittsvorrichtung mit in der oberen Seitenwand ausgebildeten federnden, zungenförmigen Seitenwandabschnitten als Vertiefungen ausgebildeten Halteelementen,
- Fig. 23: eine vergrößerte schaubildliche Ansicht des oberen Abschnittes des Grundgehäuses gemäß Fig. 22,
- Fig. 24: eine vergrößerte schaubildliche Ansicht eines Teils des oberen Abschnittes des Grundgehäuses gemäß Fig. 22,
- Fig. 25: eine vergrößerte schaubildliche Ansicht des oberen Abschnittes des Grundgehäuses mit Ansicht von unten auf die die zungenförmigen Seitenwandabschnitte aufweisenden Seitenwand,
- Fig.26 und 26A: vergrößerte schaubildliche Ansichten von als Rastnocken ausgebildeten Eingriffelementen.

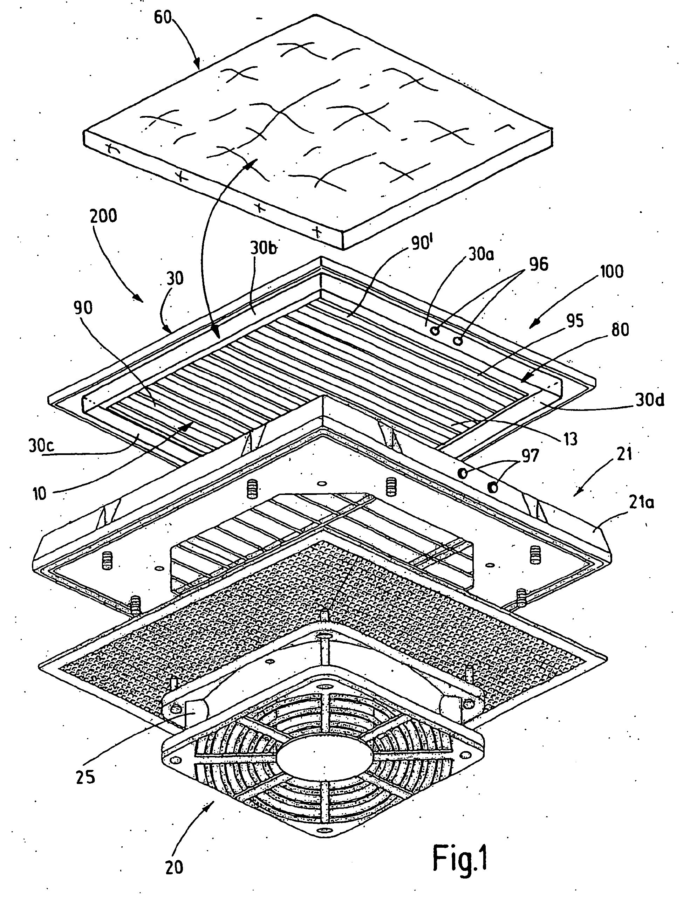

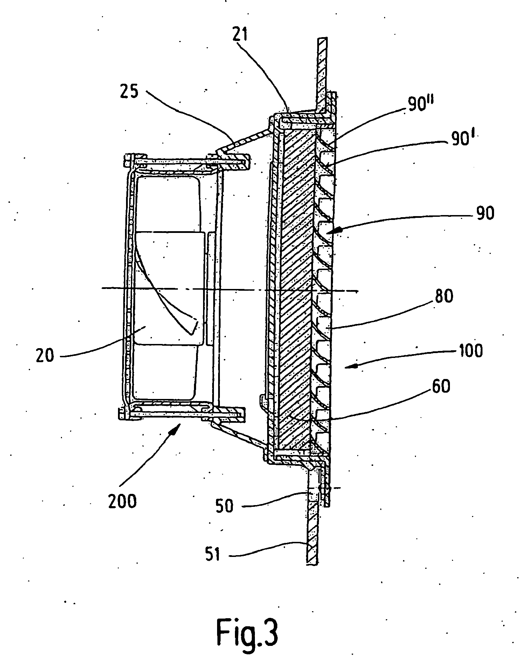

Die in Fig. 1 bis 3 dargestellte Luftdurchtrittsvorrichtung 200 einer ersten Ausführungsform der Erfindung ist in Verbindung mit einem Gebläse bzw. Ventilator als Filterlüfter und ohne Gebläse 20 als Austrittsfilter einsetzbar, Eingesetzt wird die Luftdurchtrittsvorrichtung 200 bei Gehäusen von abwärmeerzeugenden Bauteilen, wie Schaltschränke, Elektronikschränke, Computersystemen o. dgl., wobei die Luftdurchtrittsvorrichtung 200 in Montagedurchbrechungen 50 in einer Wand 51 eines derartigen Gehäuses eingebaut wird (Fig. 3).

Die wesentlichen Bauteile der Luftdurchtrittsvorrichtung 200 sind ein Designdeckel 80 mit einem Lüftergitter 10 mit Lüftungsschlitzen 13, das die vordere Abdeckvorrichtung 100 für ein Grundgehäuse 21 bildet, ein Gebläseträger 25 für das Gebläse 20, wenn die Luftdurchtrittsvorrichtung 200 als Filterlüfter eingesetzt wird (Fig. 1 bis 3).

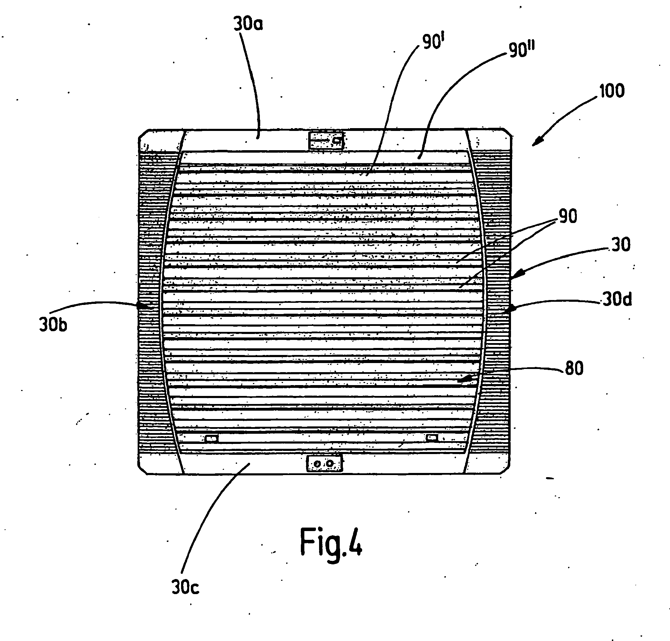

Die Abdeckvorrichtung 100, die das Lüftergitter 10 bildet, ist als Designdeckel 80 ausgebildet und besteht aus einem rahmenartigen Gehäuse 30 bevorzugter Weise mit Seitenwänden 30a, 30b, 30c, 30d und mit Lamellenelementen 90, wobei zwischen den sich abschnittsweise überlappenden Lamellenelementen 90 Lüftungsschlitze 13 ausgebildet sind. Die Filtermatte 60 kann an der Innenwandfläche des Lüftergitters 10 in dem Designdeckel 80 gehalten sein (Fig. 3) oder sie wird in das Grundgehäuse 21 eingelegt, das mittels des Designdeckels 80 verschlossen wird. Die Lamellenelemente 90 sind in zwei sich gegenüberliegenden Seitenwänden 30b, 30d des rahmenartigen Gehäuses 30 des Designdeckels 80 gehalten bzw. an diese Seitenwände angeformt (Fig. 4).

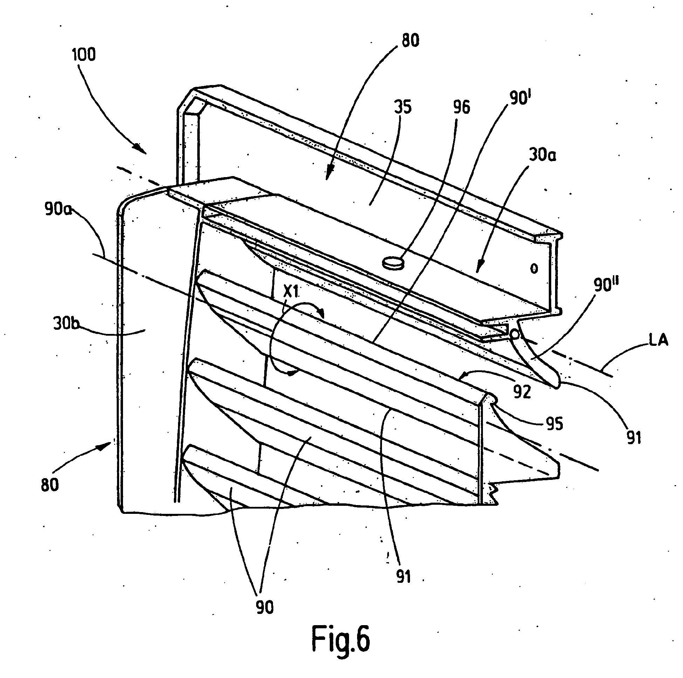

Die Abdeckvorrichtung 100 mit dem Lüftergitter 10 besteht aus dem rahmenartigen Gehäuse 30, das die Filtermatte 60 aufnimmt, einem in dem Gehäuse 30 fest, lösbar oder verschwenkbar gehaltenen und die Filtermatte 60 abdeckenden Lüftergitter 10, das den Designdeckel 80 bildet. Dieses Lüftergitter 10 umfasst mindestens zwei laterale, sich randseitig in einer Längsrichtung erstreckende, vorzugsweise wangenförmig ausgebildeten Seitenwänden 30b, 30d, zwischen denen die Lamellenelemente 90 angeordnet sind (Fig. 4, 5 und 8). Die Lamellenelemente 90 sind bei gleichzeitiger abschnittsweiser Überdeckung in einem Abstand voneinander angeordnet und derart schräg gestellt, dass die jeweils vorderen und außenliegenden Lamellenkanten 91 gegenüber den rückwärtigen Lamellenkanten 92 tiefer gelegen sind. Die oberen rückwärtigen Lamellenkanten 92 weisen bevorzugter Weise widerhakenartig bzw. hakenartig ausgebildete Formgebungen 95 auf (Fig. 6), um das Eindringen von Wasser zu verhindern und um auf den Designdeckel 80 einwirkendes Wasser abzuleiten.

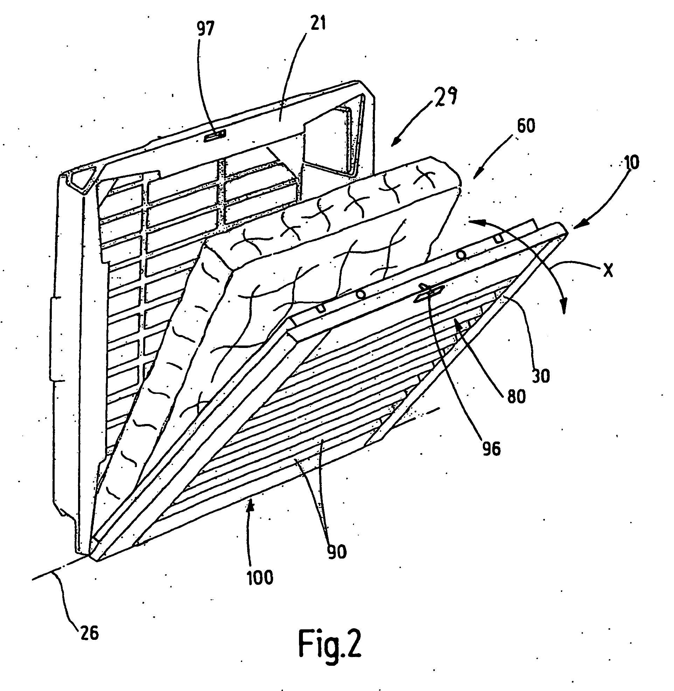

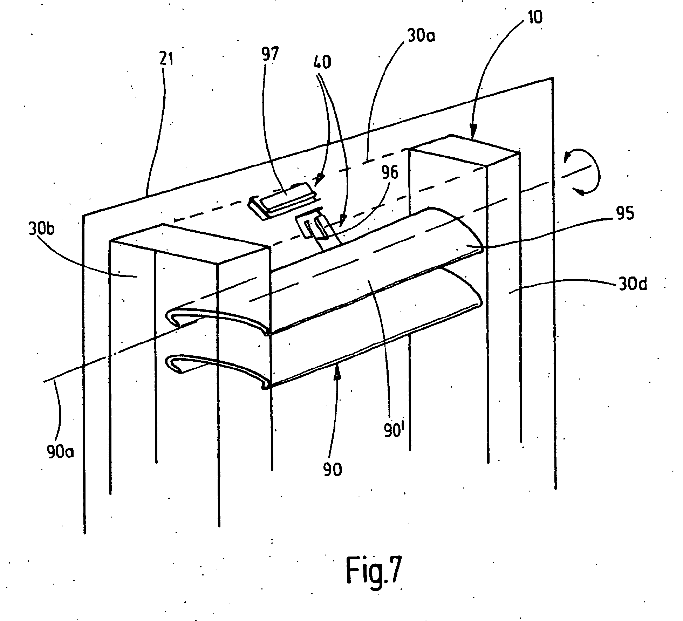

Der die Filtermatte 60 aufnehmende Designdeckel 80 bzw. das Lüftergitter 10 ist zum Öffnen der Aufnahmekammer für die Filtermatte zwischen dem Lüftergitter 10 und dem Grundgehäuse 21 um seine bodenseitige Schwenkachse 26 in Pfeilrichtung X verschwenkbar (Fig. 2). Das Arretieren des Lüftergitters 10 an dem Grundgehäuse 21 erfolgt bevorzugter Weise im oberen Bereich z. B. vermittels einer Arretierungsvorrichtung 40, bevorzugter Weise aus den Bauteilen 96, 97, die als Rastnocken und Einrastelementen ausgebildet sind (Fig. 2 und 7).

Die Betätigung der Arretierungsvorrichtung 40 erfolgt vermittels Lamellenelementen 90' oder eines Lamellenelementes 90" der Lamellenelemente 90 des Lüftergitters 10. Bei der in Fig. 6 und 7 gezeigten Ausführungsform ist das oberste Lamellenelement 90' als Betätigungselement ausgebildet. Hierzu ist das Lamellenelement 90' in den beiden Seitenwänden 30b, 30d des rahmenartigen Rahmens 30 in Pfeilrichtung X1 verschwenkbar derart gehalten, dass das Lamellenelement 90' um seine Längsachse 90a als Schwenk- und Drehachse verschwenkbar ist (Fig. 6 und 7). Bevorzugter Weise ist das Lamellenelement 90' um eine mittig in Längsrichtung des Lamellenelementes 90' verlaufende Schwenkachse 90a verschwenkbar. Die obere, rückwärtige Lamellenkante 92 ist dann mit den Bauteilen der Arretierungsvorrichtung 40 versehen, wobei die Arretierungsvorrichtung mittig an dem Lamellenelement 90' angeformt bzw. befestigt ist, jedoch auch eine außermittige Anordnung ist möglich (Fig. 7). Auch besteht die Möglichkeit, an einem Ende oder an beiden Enden des Lamellenelementes 90' die Arretierungsvorrichtung 40 vorzusehen, so dass die Bauteile dieser Vorrichtung dann jeweils an den Endbereichen des Lamellenelementes 90' und an den jeweils gegenüberliegenden Wandflächen des Grundgehäuses 21 vorgesehen sind, so dass die Bauteile zum Verriegeln ineinander greifen können.

Mindestens ein Lamellenelement 90' und zwar bevorzugter Weise das jeweils oberste Lamellenelement des Lüftergitters 10 ist verschwenkbar in diesem gehalten. Vermittels Fingerbetätigung wird das Lamellenelement 90' verschwenkt, so dass die Arretierung bzw. Verriegelung zwischen dem Lüftergitter 10 und dem Grundgehäuse 21 gelöst wird, so dass beim Verschwenken des Lüftergitters in Pfeilrichtung X nach außen die Filtermatte 60 zur Entnahme freigegeben wird (Fig. 2). Werden der Designdeckel 80 und das Grundgehäuse 21 zusammengeklappt, dann rasten die Bauteile der Arretierungsvorrichtung 40 ineinander ein.

Die an dem Designdeckel 80 und dem Grundgehäuse 21 ausgebildete Arretierungsvorrichtung 40 weist z. B. an der mitschwenkenden Längskante des Lamellenelementes 90' bei dessen Betätigung einen Rastnocken 96 auf, der zur Ausbildung einer Rastverbindung mit einem hakenförmigen oder ausnehmungsartigen Rastelement 97 in Wirkverbindung bringbar ist, so dass beim Schließen des Designdeckels 80 der Rastnocken 96 in sein Gegenelement einrastet, wohingegen auch die Möglichkeit besteht, dass auch bei Nichtbetätigung des Lamellenelementes 90' beim Schließen des Designdeckels 80 die Rastverbindung hergestellt wird. Zum Öffnen der Rastverbindung wird dann das Lamellenelement 90' bei einer Fingerbetätigung verschwenkt, wobei der Rastnocken 96 aus seiner Eingriffsposition an dem Grundgehäuse 21 herausschwenkt und den Designdeckel 80 zum Verschwenken in die Filterentnahmeposition freigibt (Fig. 2).

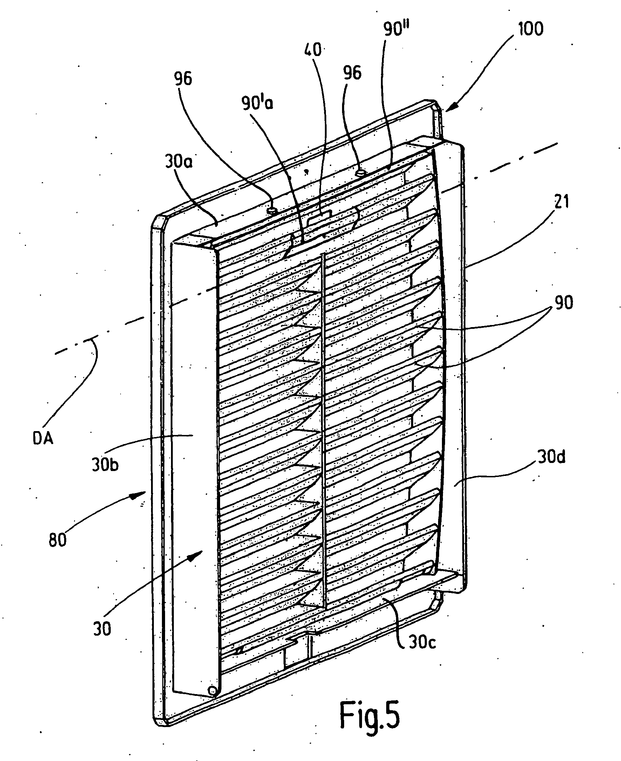

Eine weitere Ausführungsform der Erfindung sieht vor, dass nur ein Abschnitt 90'a des obersten Lamellenelementes 90' um eine in Längsrichtung des Lamellenelementes 90' verlaufende Drehachse DA in dem Lüftergitter 10 verschwenkbar ausgebildet ist (Fig. 5).

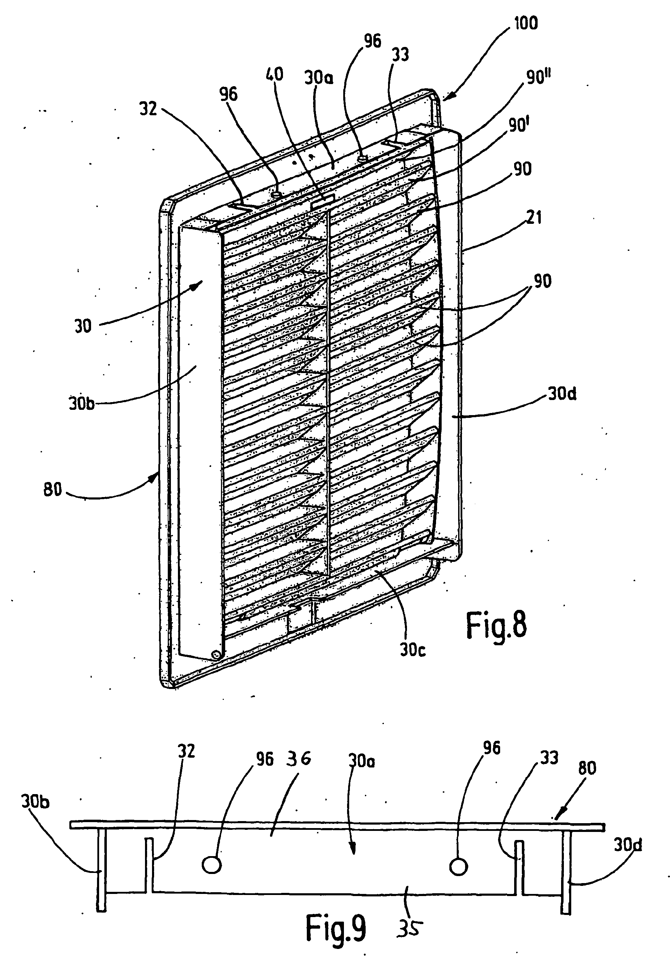

Bei der in Fig. 8 und 9 gezeigten Ausführungsform einer Luftdurchtrittsvorrichtung ist in der dem obersten mit seiner Längskante an der oberen Seitenwand 30a des rahmenartigen Gehäuses 30 des Designdeckels 80 angeformten Lamellenelement 90" des Designdeckels 80 zugekehrten Seitenwand 30a durch quer zur Seitenwandlängsrichtung verlaufende Schlitze 32, 33 ein Seitenwandabschnitt 35 ausgebildet, der im Bereich seiner Anformung 36 an dem Lüftergitter 10 um seine Längsachse LA verschwenkbar ist. Dieser Seitenwandabschnitt 35 trägt mindestens einen Rastnocken 96, der zur Ausbildung der Rastverbindung in Eingriff mit einer Durchbrechung 97 an der mit der Seitenwand 30a des Lüftergitters 10 korrespondierenden Seitenwand 21 a des Gehäuses 21 bringbar ist (Fig. 1). Die Betätigung des Seitenwandabschnittes 35 erfolgt bei dieser Ausführungsform über das Lamellenelement 90", das im oberen Bereich des Designdeckels 80 ausgebildet ist. Dieser Seitenwandabschnitt 35 des rahmenartigen Gehäuses 30 des Designdeckels 80 ist mit seiner Längskante an dem Lamellenelement 90" angeformt, das jedoch mit seinen Endbereichen nicht mit den sich gegenüberliegenden Seitenwänden 30b, 30d des Designdeckels 80 verbunden ist (Fig. 6). Im Bereich dieser Anformung des Lamellenelementes 90" an dem Seitenwandabschnitt 35 der Seitenwand 30a des Designdeckels 80 liegt die Längsachse LA für das Verschwenken des Seitenwandabschnittes 35 bei Fingerbetätigung des Lamellenelementes 90". Diese Längsachse LA ist gleichzeitig die Drehachse. Durch ein Anheben des Lamellenelementes 90" wird der mit diesem fest verbundene Seitenwandabschnitt 35 bewegt, so dass die Rastverbindung geöffnet werden kann. Aufgrund der Verwendung von federnd-elastischem Kunststoff ist das Verschwenken des Lamellenelementes 90" und die Herstellung der Rastverbindung möglich, indem der oder die Rastnocken 96 an dem Seitenwandabschnitt 35 in die Durchbrechungen bzw. Ausnehmungen 97 an der Seitenwand 21 a des Gehäuses 21 einrasten, wenn der Designdeckel 80 mit dem Gehäuse 21 miteinander lösbar verbunden wird.

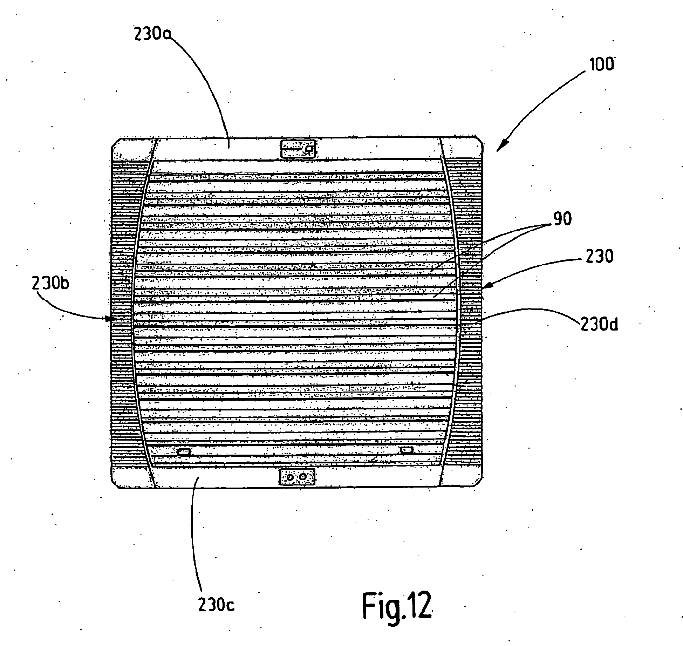

Die in Fig. 10 bis 12 dargestellte Luftdurchtrittsvorrichtung 200 der zweiten Ausführungsform der Erfindung ist in Verbindung mit einem Gebläse bzw. Ventilator als Filterlüfter und ohne Gebläse 20 als Austrittsfilter einsetzbar. Eingesetzt wird die Luftdurchtrittsvorrichtung 200 bei Gehäusen von Abwärme erzeugenden Bauteilen, wie Schaltschränke, Elektronikschränke, Computersystemen o. dgl., wobei die Luftdurchtrittsvorrichtung 200 in Montagedurchbrechungen 250 in einer Wand 251 eines derartigen Gehäuses eingebaut wird (Fig. 12).

Die wesentlichen Bauteile der Luftdurchtrittsvorrichtung 200 sind ein Designdeckel 280 mit einem Lüftergitter 210 mit Lüftungsschlitzen 290, das die vordere Abdeckvorrichtung 100 für ein Grundgehäuse 221 bildet und ein Gebläseträger 225 für das Gebläse 220, wenn die Luftdurchtrittsvorrichtung 200 als Filterlüfter eingesetzt wird (Fig. 10 bis 12).

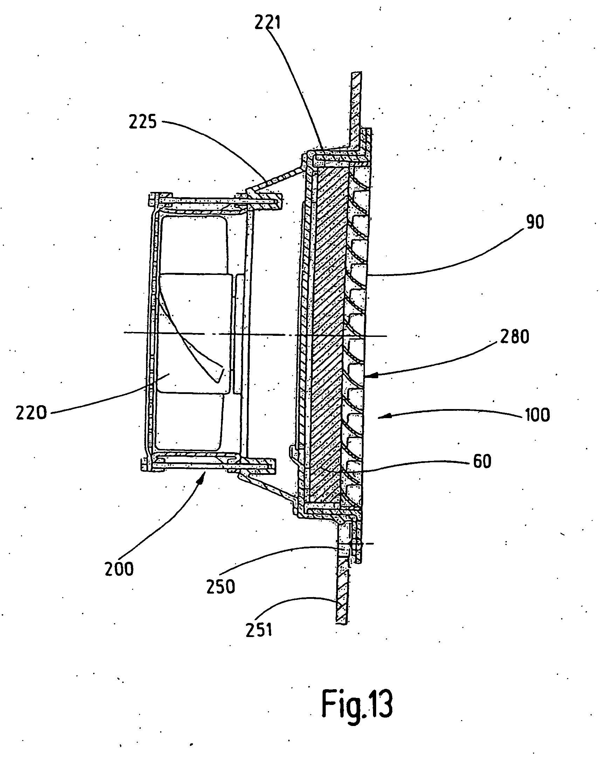

Die Abdeckvorrichtung 100, die das Lüftergitter 210 bildet, ist als Designdeckel 280 ausgebildet und besteht aus einem Rahmen 230 mit Seitenwänden 230a, 230b, 230c, 230d und bei der in der Zeichnung dargestellten Ausführungsform mit Lamellenelementen 90, wobei zwischen den sich abschnittsweise überlappenden Lamellenelementen 90 Lüftungsschlitze 290 ausgebildet sind. Die Filtermatte 60 ist an der Innenwandfläche des Lüftergitters 210 in dem Rahmen des Designdeckels 280 gehalten (Fig. 12) oder sie wird in das Grundgehäuse 221 eingelegt, das mittels des Designdeckels 280 verschlossen wird. Die Lamellenelemente 90 sind in zwei sich gegenüberliegenden Seitenwänden 230b, 230d des Rahmens 230 des Designdeckels 280 gehalten bzw. an diese Seitenwände angeformt (Fig. 13). Der Designdeckel 280 ist um die Schwenkachse 226 verschwenkbar, um den Designdeckel zur Entnahme der Filtermatte 60 öffnen zu können. Der Designdeckel 280 kann auch gitterförmig ausgebildet sein.

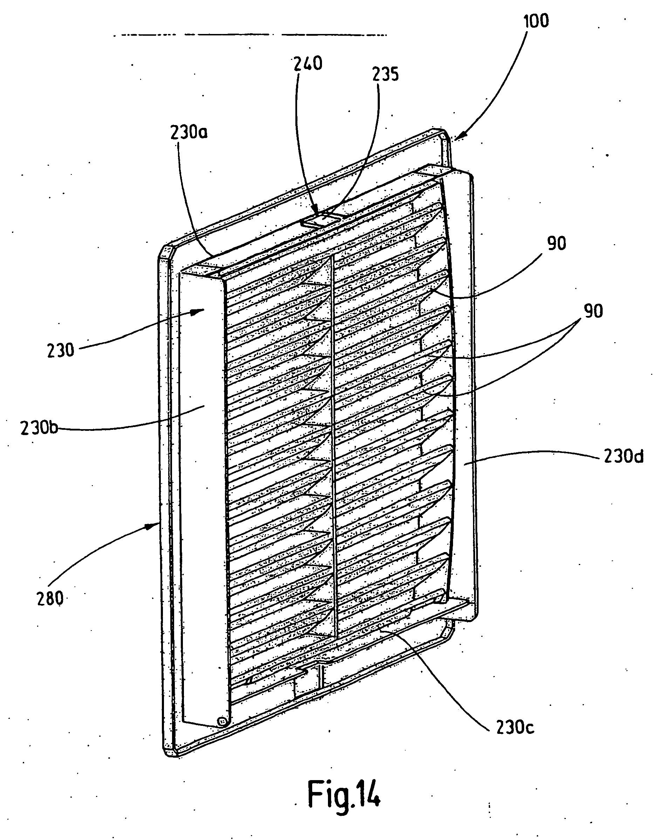

Die Abdeckvorrichtung 100 mit dem Lüftergitter 210 besteht somit aus dem Rahmen 230, der die Filtermatte 60 aufnimmt, einem in dem Rahmen 230 fest, lösbar oder verschwenkbar gehaltenen und die Filtermatte 60 abdeckenden Lüftergitter 210, das den Designdeckel 280 bildet. Dieses Lüftergitter 210 umfasst mindestens zwei laterale, sich randseitig in einer Längsrichtung erstreckende, vorzugsweise wangenförmig ausgebildeten Seitenwänden 230b, 230d, zwischen denen die Lamellenelemente 90 angeordnet sind (Fig. 13 und 14). Die Lamellenelemente 90 sind bei gleichzeitiger abschnittsweiser Überdeckung in einem Abstand voneinander angeordnet und derart schräg gestellt, dass die jeweils vorderen und außenliegenden Lamellenkanten 91 gegenüber den rückwärtigen Lamellenkanten 92 tiefer gelegen sind.

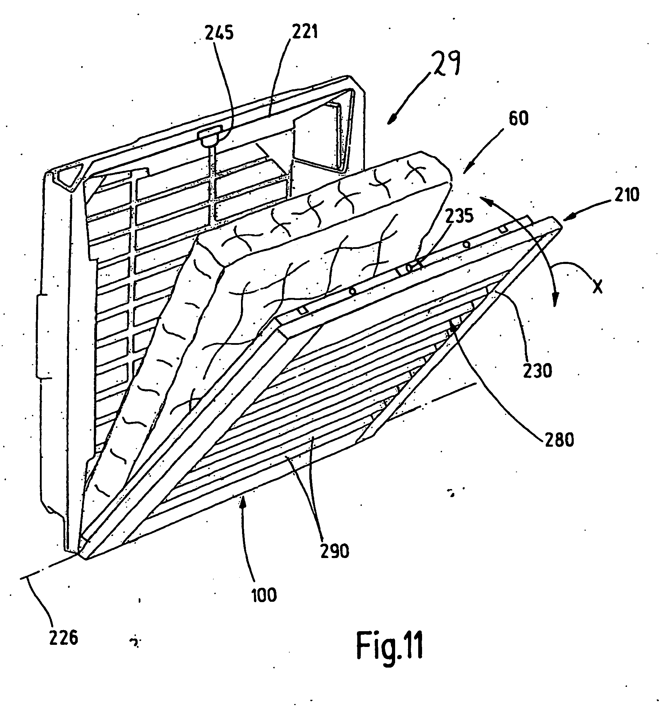

Der die Filtermatte 60 aufnehmende Designdeckel 280 bzw. das Lüftergitter 210 ist zum Öffnen der von dem Rahmen 230 gebildeten Aufnahmekammer für die Filtermatte zwischen dem Lüftergitter 210 und dem Grundgehäuse 221 um seine bodenseitige Schwenkachse 226 in Pfeilrichtung X verschwenkbar (Fig. 11). Das Arretieren des Lüftergitters 210 an dem Grundgehäuse 221 erfolgt bevorzugter Weise im oberen Bereich z. B. vermittels einer Rastvorrichtung 240, bevorzugter Weise aus den Bauteilen 296, 297, die als Eingriffelement und als Halteelement ausgebildet sind (Fig. 10, 11, 15 und 16). Das Grundgehäuse 221 besteht aus einer Gitterwand 325 und einem an dieser angeformten Rahmen 321 mit den Seitenwänden 221a, 221b, 221c, 221d. Ist der Designdeckel 280 an das Grundgehäuse 221 herausgeklappt, dann kommen die Seitenwände 230a, 230b, 230c, 230d des Designdeckels 280 an den Innenwandflächen der Seitenwände 221a, 221b, 221c, 221d des Rahmens 321 des Grundgehäuses 221 zu liegen, d. h. die Seitenwände des Rahmens des Grundgehäuses 221 übergreifen die Seitenwände des Rahmens des Designdeckels 280, so dass die Seitenwände 230a und 221 a, 230b und 221b, 230c und 221c und 230d und 221d miteinander korrespondieren.

Der Designdeckel 280 greift somit mit seinen umlaufenden Seitenwänden 230a, 230b, 230c, 230d in die umlaufenden Seitenwände 221a, 221b, 221c, 221d des Grundgehäuses 221, so dass im zusammengeklappten Zustand der Designdeckel 280 auf dem Grundgehäuse 221 liegt und von diesem gehalten ist, wobei die jeweils der Schwenkachse 226 des Designdeckels 280 abgekehrten Seitenwände 230a, 221a des Designdeckels 280 und des Grundgehäuses 221 aufeinander liegen. Die Seitenwand 221a des Grundgehäuses 221 übergreift dabei die Seitenwand 230a des Designdeckels 280.

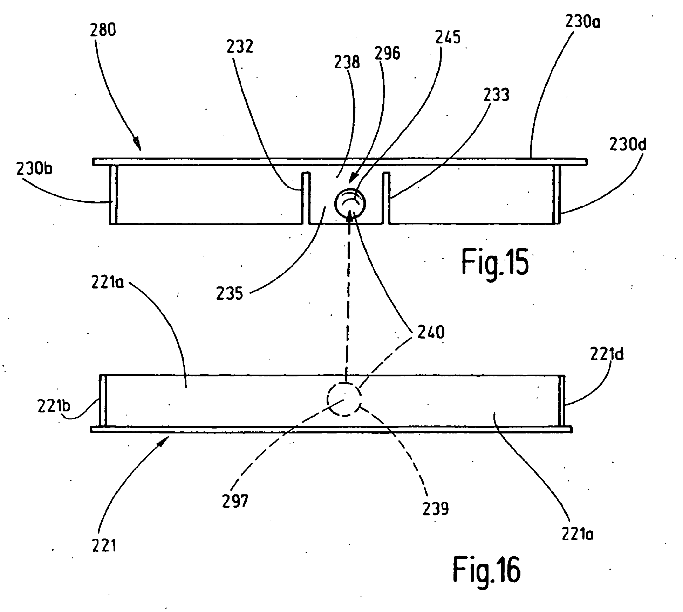

Die Rastverbindung 240 (Fig. 15 und 16), vermittels der der Designdeckel 280 an dem Grundgehäuse 221 lösbar gehalten ist, besteht aus mindestens einem in der Seitenwand 230a des Designdeckels 280 ausgebildeten federnden zungenförmigen Seitenwandabschnitt 235, der vermittels quer zur Seitenwandlängsrichtung verlaufender Schlitze 232, 233 in der Seitenwand 230a ausgebildet ist. Dieser zungenförmige Seitenwandabschnitt 235 ist federnd-elastisch an einem Steg 238 der Seitenwand 230a des Designdeckels 280 gehalten, so dass dieser zungenförmige Seitenwandabschnitt 235 einem auf den Seitenwandabschnitt 235 ausgeübten Druck ausweichen kann und bei Druckentlastung in seine Ausgangsposition zurückfedern kann (Fig. 14, 15 und 16).

Die federnd-elastische Ausgestaltung des zungenförmigen Seitenwandabschnittes 235 einer abgebogenen Stellung in die Ausgangsstellung wird erreicht durch das für die Herstellung des Designdeckels 280 verwendete Material, wobei es sich um Kunststoff oder um ein Metall handelt, wobei die Materialien federnd-elastische Eigenschaften aufweisen müssen.

Der zungenförmige Seitenwandabschnitt 235 weist außenwandseitig ein Eingriffelement 296, z. B. in Form eines Rastnockens 245 auf, das mit einem Halteelement 297 zusammenwirkt, das an der Unterseite der Seitenwand 221 a des Grundgehäuses 221 ausgebildet ist. Dieses Halteelement 297 ist beispielsweise als Vertiefung oder Ausnehmung 239 mit einer Formgebung ausgebildet, die der Formgebung des Rastnockens 245 entspricht. Dieser Rastnocken 245 weist eine der Vertiefung 239 entsprechende Formgebung auf, so dass bei geschlossenem Designdeckel 280 der Rastnocken 245 in die Vertiefung 239 in der Seitenwand 221 a des Grundgehäuses 221 einrastet, so dass der Designdeckel 280 mit dem Grundgehäuse 221 verriegelt ist. Anstelle einer Vertiefung 239 kann auch in der Seitenwand 221a des Grundgehäuses 221 eine Durchbrechung vorgesehen sein, in die der Rastnocken 245 beim Schließen des Designdeckels 280 einrastet. Die Vertiefung 239 kann des Weiteren auch halbkugelförmig oder als Sacklochbohrung ausgebildet sein. Dadurch, dass der zungenförmige Seitenwandabschnitt 235 federnd-elastisch ist, wird dieser, wenn der Rastnocken 245 in Richtung zur Vertiefung 239 beim Schließen des Designdeckels 280 bewegt wird, nach unten abgebogen und federt aufgrund seines Rückstellvermögens in seine Ausgangsposition, d. h. in die von der Seitenwand 230a gebildeten Ebene zurück, wenn der Rastnocken 245 in der Vertiefung 239 zu liegen kommt (Fig. 15, 16, 17 und 18).

Bei dem in der Zeichnung dargestellten Ausführungsbeispiel ist die Rastverbindung 240 aus den beiden Bauteilen 296, 297 mittig in den Seitenwänden 221 a, 230a des Grundgehäuses 221 und des Designdeckels 280 vorgesehen. Die Anzahl der Rastverbindungen 240 kann jedoch beliebig gewählt sein; sie richtet sich jeweils nach der Größe der Luftdurchtrittsvorrichtung.

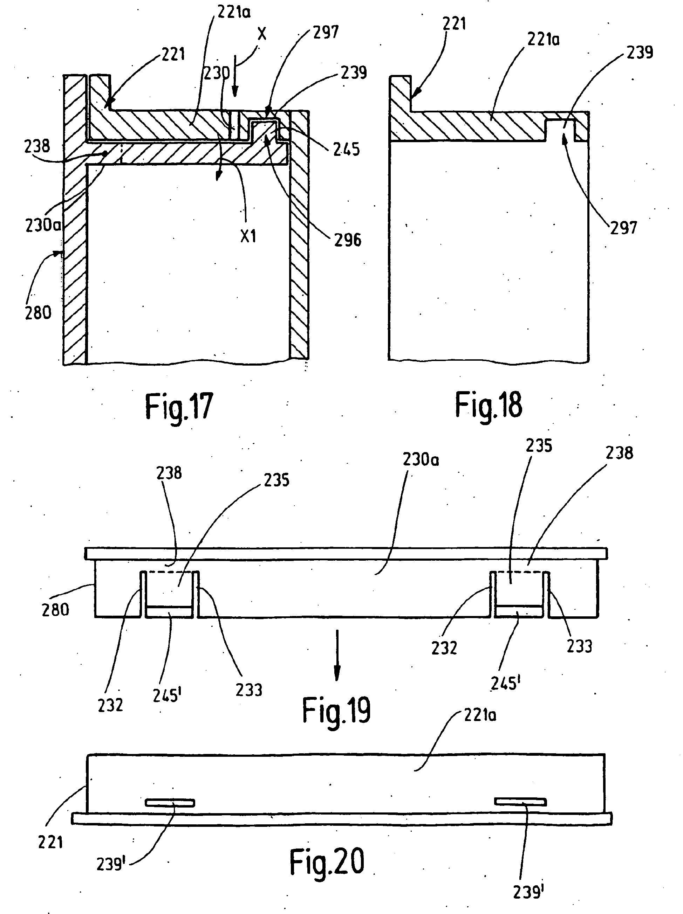

Ist der Designdeckel 280 in das Grundgehäuse 221 eingeklappt, dann liegen die beiden Seitenwände 221 a und 230a übereinander, so dass das Eingriffelement 296 in Wirkverbindung mit Halteelement 297 steht. Soll die Rastverbindung 240 zwischen dem Eingriffelement 296 und dem Halteelement 297 zum Öffnen des Designdeckels 280 gelöst werden, dann muss der zungenförmige Seitenwandabschnitt 235 in der Seitenwand 230a des Designdeckels 280 in Richtung zur Schwenkachse 226 des Designdeckels 280 abgebogen werden, damit das Eingriffelement 296, also der Rastnocken 245, aus der Vertiefung 239 in der Seitenwand 221 a des Grundgehäuses 221 bewegt wird. Dieses Abbiegen kann beispielsweise mittels eines stiftartigen Gegenstandes wie z. B. eines Schraubendrehers erfolgen. Um dies zu ermöglichen, kann die Seitenwand 221 a des Grundgehäuses 221 mit einer schlitzförmigen Ausnehmung oder Durchbrechung 330 versehen sein, die oberhalb des zungenförmigen Seitenwandabschnittes 235 in der Seitenwand 221 a des Grundgehäuses 221 angeordnet ist, so dass der Betätigungsgegenstand durch die Durchbrechung 330 hindurchgeführt und bei einer Abwärtsbewegung in Pfeilrichtung X gegen den zungenförmigen Seitenwandabschnitt 235 gedrückt wird, wodurch dieser in Pfeilrichtung X1 abgebogen wird (Fig. 17, 18 und 21).

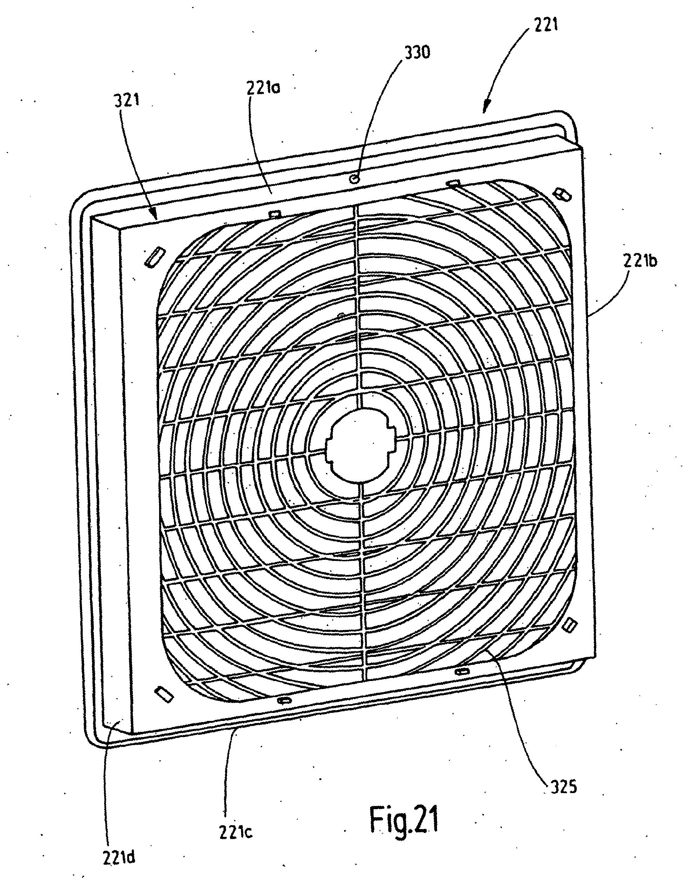

Bei der Ausführungsform nach Fig. 20 und 21 sind in den oberen Bereichen bzw. in den Seitenwänden 221a, 230a des Designdeckels 280 und des Grundgehäuses 221 zwei zungenförmige Seitenwandabschnitte 235 und zwei mit den zungenförmigen Seitenwandabschnitten 235 korrespondierende Halteelemente 297 in den jeweiligen Seitenwänden 230a, 221a der Rahmen 230, 221 des Designdeckels 280 und des Grundgehäuses 221 vorgesehen.

Die beiden zungenförmigen Seitenwandabschnitte 235 sind ebenfalls fedemd-elastisch ausgebildet und über die Stege 238 mit dem Material des Designdeckels 280 verbunden. An ihren freien Enden weisen die zungenförmigen Seitenwandabschnitte 235 im rechten Winkel abgebogene Abschnitte 245' auf, die die Eingriffelemente 296 bilden (Fig. 19). Diese abgebogenen Abschnitte 245' greifen bei geschlossenem Designdeckel 280 in schlitzförmige Ausnehmungen bzw. Vertiefungen oder Durchbrechungen 239', die in der mit der Seitenwand 230a des Designdeckels 280 korrespondierenden Seitenwand 221 a des Grundgehäuses 221 vorgesehen sind (Fig. 20).

Die vorangegangenen Ausführungsbeispiele gehen davon aus, dass die Rastverbindung 240 gegenüber der Schwenkachse für den Designdeckel 280 vorgesehen ist, also im oberen Bereich der Luftdurchtrittsvorrichtung. Erfindungsgemäß ist jedoch vorgesehen, dass der Designdeckel 280 an jeder beliebigen Seitenwand 221a, 221b, 221c, 221d des Rahmens 321 des Grundgehäuses 221 verschwenkbar angeordnet ist, wobei die Rastverbindung 240 für den Designdeckel 280 und dem Grundgehäuse 221 an dem der Schwenkachse für den Designdeckel 280 gegenüberliegenden Seitenwänden des Designdeckels 280 und dem Grundgehäuse 221 vorgesehen ist.

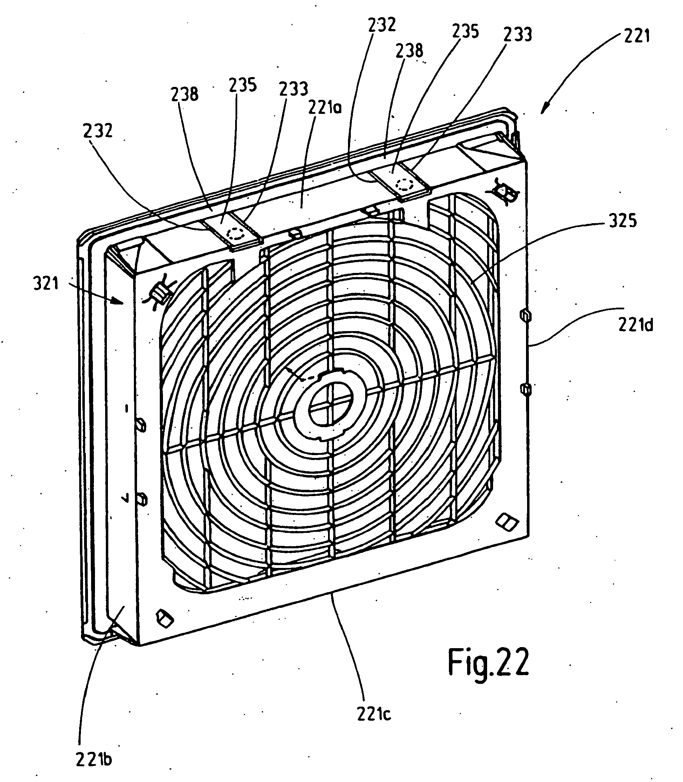

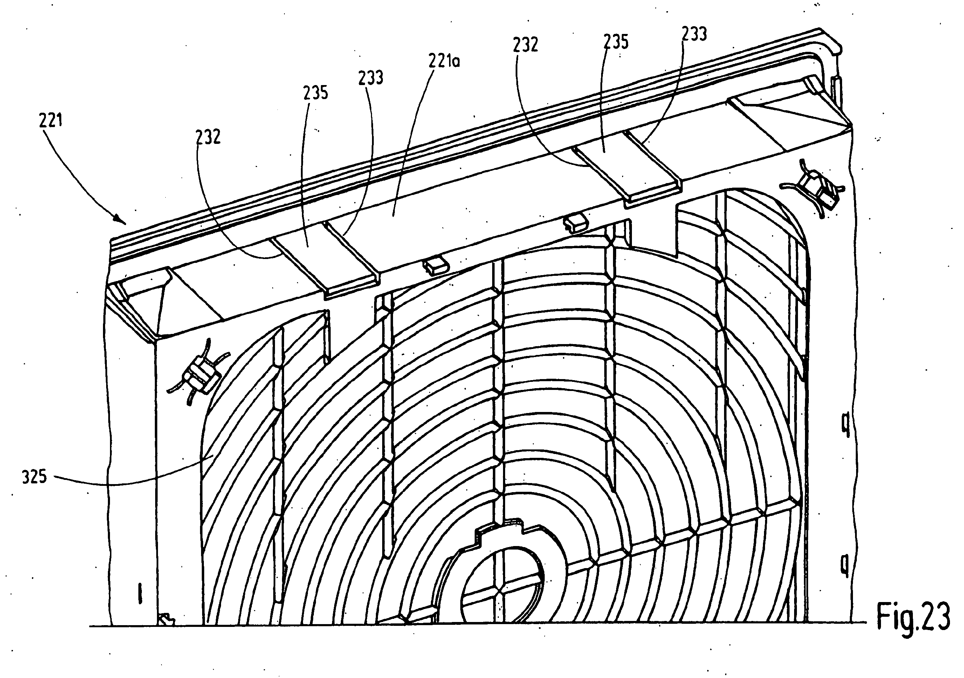

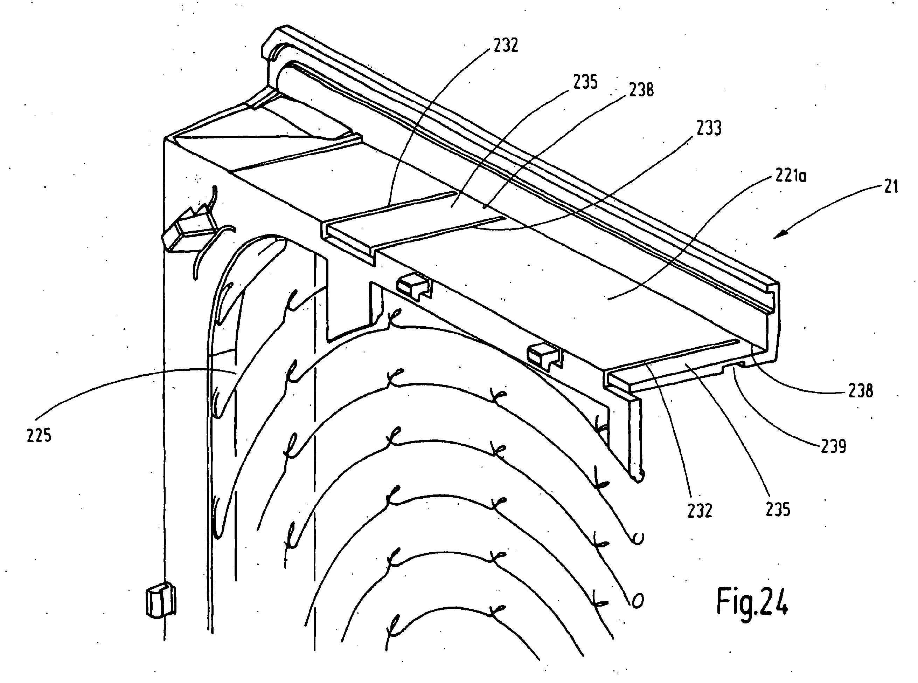

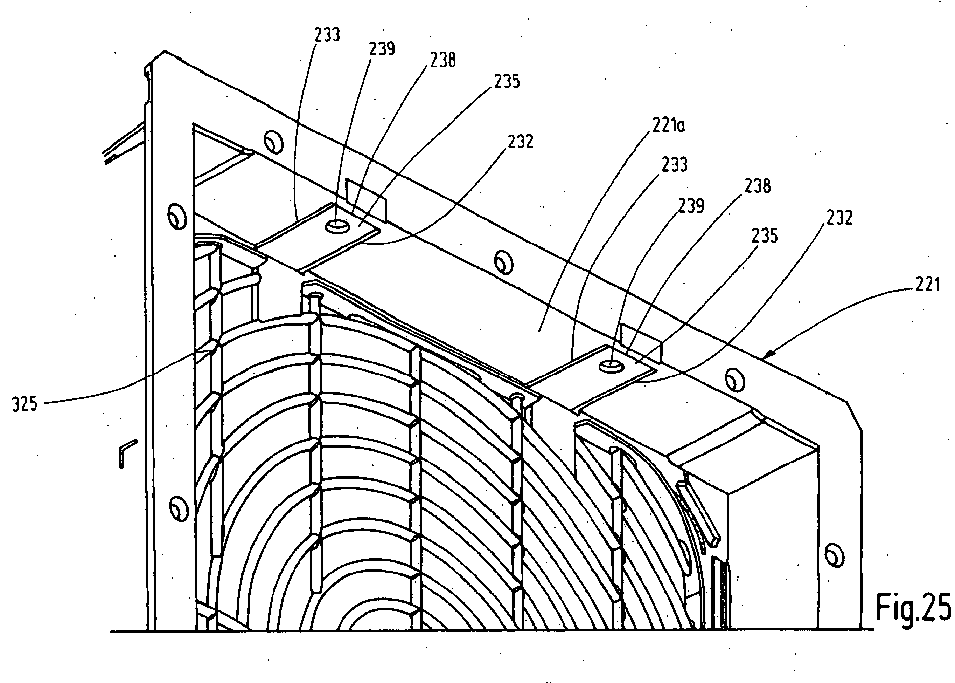

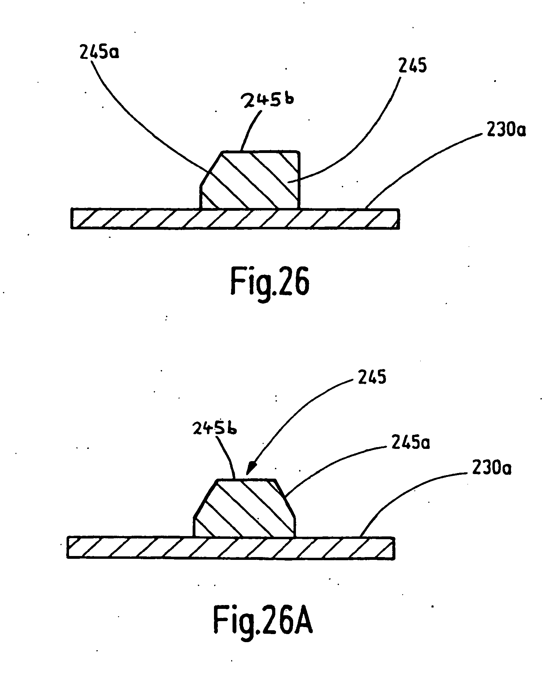

Bei der Ausführungsform gemäß Fig. 22 bis 25 sind zur Herstellung der lösbaren Rastverbindung 240 zwischen dem Designdeckel 280 und dem Grundgehäuse 221 der Luftdurchtrittsvorrichtung in der oberen Seitenwand 221 a des Rahmens 321 des Grundgehäuses 221 zwei aus dem Material der Seitenwand 221a durch quer zur Seitenwandlängsrichtung verlaufende Schlitze 232, 233 von der übrigen Seitenwandfläche getrennte federnde zungenförmige Seitenwandabschnitt 235 ausgebildet. Jeder zungenförmige Seitenwandabschnitt 235 ist vermittels eines Steges 238 in der Seitenwand 221a gehalten. Der zungenförmige Wandabschnitt 235 ist innenwandseitig mit einem Halteelement 297 in Form einer bevorzugter Weise kreisrunden Vertiefung 239 oder Durchbrechung, Bohrung oder Sacklochbohrung versehen. Diese Vertiefung 239 ist mit einem Eingriffelement 296 des Designdeckels 280 in Form eines Rastnockens 245 in Wirkverbindung bringbar. Dieser Rastnocken 245 ist an der Seitenwand 230a des Designdeckels 280 angeordnet bzw. angeformt, die mit der das Halteelement 297 aufweisenden Seitenwand 221a des Grundgehäuses 221 korrespondiert. Der Rastnocken 245 weist an seinem freien Ende einen zum Rastnockenende hin konisch verlaufenden Abschnitt 245a auf (Fig. 26 und 26A). Anstelle eines abgeschrägten Abschnittes 245a kann der Rastnocken 245 auch einen umlaufenden konisch zum Rastnockenende 245b verlaufenden Abschnitt aufweisen.

Bei der vorangehend beschriebenen Ausführungsform weisen die Seitenwände 221a, 230a je zwei zungenförmige Seitenwandabschnitte 235 mit Halteelementen 297 und mit diesen korrespondierende Eingriffelemente 296 auf. Die Rastverbindung 240 kann auch mit einem Halteelement 297 und einem Eingriffelement 296 hergestellt werden.

Das Zusammenwirken der Halteelemente 297 mit den Eingriffelementen 296 erfolgt bei einer Ausführungsform gemäß Fig. 22 bis 25 wie folgt: Ist der Designdeckel 280 geöffnet und wird an das Grundgehäuse 221 herangeklappt, dann gleitet der zungenförmige Seitenwandabschnitt 235 der Seitenwand 221a des Grundgehäuses 221 über den Rastnocken 245 der Seitenwand 230a des Designdeckels 280, wobei der zungenförmige Seitenwandabschnitt 235 aufgrund seiner federnden Eigenschaft leicht angehoben wird, so dass das freie Ende des zungenförmigen Seitenwandabschnittes 235 über den Rastnocken 245 gleitet. Diese Gleitbewegung wird unterstützt durch den abgeschrägten Abschnitt 245a am Ende des Rastnockens 245. Der zungenförmige Seitenwandabschnitt 235 gleitet beim Schließen des Designdeckels 280 soweit über den Rastnocken 245, bis der Rastnocken 245 in die Vertiefung 239 an der Unterseite des zungenförmigen Seitenwandabschnittes 235 einrastet. Dieses Einrasten wird unterstützt durch das Rückstellvermögen des zungenförmigen Seitenwandabschnittes 235 aus der abgebogenen Stellung in die Ausgangsstellung, d. h. in die Ebene der Seitenwand 221 a des Grundgehäuses 221. Im geschlossenen Zustand liegt der Designdeckel 280 an dem Grundgehäuse 221 an, wobei die umlaufenden Seitenwände 221a, 221 b, 221 c, 221 d des Grundgehäuses die umlaufenden Seitenwände 230a, 230b, 230c, 230d des Designdeckels 280 übergreifen.

Das Öffnen des Designdeckels 280 erfolgt durch ruckartiges Abziehen des Designdeckels vom Grundgehäuse, wobei der Rastnocken 245 aus der Vertiefung 239 gleitet. Dieses Abziehen wird unterstützt durch eine konische Randausgestaltung der Vertiefung 239 und durch den abgeschrägten Endabschnitt 245a des Rastnockens 245.

## Patentansprüche

1. Luftdurchtrittsvorrichtung, insbesondere Filterlüfter oder Austrittsfilter, für den Einbau in eine Montagedurchbrechung (50) in einer Wand (51), insbesondere eines Gehäuses für Abwärme erzeugenden Bauteilen, wie Schaltschrank, Elektronikschrank, Computersystem o. dgl., wobei die Luftdurchtrittsvonichtung (200) ein Grundgehäuse (21; 221) mit einem umlaufenden Rahmen (321) aus Seitenwänden (21a, 21b, 21c, 21d; 221a, 221b, 221c, 221d) und einen Designdeckel (80; 280) mit einem luftaustrittseitig angeformten, umlaufenden Rahmen (30; 230) aus Seitenwänden (30a, 30b, 30c, 30d; 230a, 230b, 230c, 230d) umfasst, der mit seinen Seitenwänden in die Seitenwände des Rahmens (321) des Grundgehäuses (21; 221) eingreift und der eine Filtermatte (60) aufnimmt, wobei der Designdeckel (80; 280) lufteintrittsseitig eine als Lüftungsgitter (10; 210) mit bevorzugter Weise an zwei sich gegenüberliegenden Seitenwänden des Designdeckels (80; 280) gehaltenen Lamellenelementen (90, 90'; 290, 290') ausgebildete Abdeckvorrichtung (100) aufweist und wobei der Designdeckel (80; 280) an dem Grundgehäuse (21; 221) um eine waagerechte oder senkrechte Schwenkachse (26; 226) zur Freigabe einer Entnahmeöffnung (29) für die Entnahme bzw. Einführung der Filtermatte (60) zum Zwecke eines Filtermattenwechsels angeordnet ist,
**dadurch gekennzeichnet,**
**dass** mindestens ein verschwenkbares Lamellenelement (90) oder durch quer zur Seitenwandlängsrichtung verlaufende Schlitze (332, 333) von der übrigen Seitenwandfläche getrennt mindestens ein federnder, zungenförmiger Seitenwandabschnitt (235) im Bereich der der Schwenkachse (26; 226) zum Verschwenken des Designdeckels (80; 280) abgekehrten, oberen Seitenwand des Designdeckels (80; 280) oder oberen Seitenwand (221a) des Rahmens (321) des Grundgehäuses (221) ausgebildet ist, wobei das Lamellenelement (90) und der zungenförmige Seitenwandabschnitt (235) als fingerbetätigbare, lösbare und verriegelbare Rastverbindung (40; 240) zwischen dem Designdeckel (80; 280) und dem Grundgehäuse (21; 221) ausgebildet sind.

2. Luftdurchtrittsvorrichtung nach Anspruch 1,
**dadurch gekennzeichnet,**
**dass** mindestens ein Lamellenelement (90), bevorzugter Weise das oberste Lamellenelement (90'), oder ein Abschnitt des Lamellenelementes (90') oder ein nur mit der oberen Seitenwand (30a) des Designdeckels (80) mit seiner Längskante verbundenes Lamellenelement (90") des Lüftergitters (10) um eine in Längsrichtung des Lamellenelementes verlaufende Drehachse (DA) in dem Lüftergitter (10) verschwenkbar angeordnet und als fingerbetätigbares Betätigungselement (95) für eine Arretierungseinrichtung (40) zum Verriegeln und Lösen einer Verriegelung zwischen dem Lüftergitter (10) und dem Grundgehäuse (21) ausgebildet ist.

3. Luftdurchtrittsvorrichtung nach Anspruch 1,
**dadurch gekennzeichnet,**
**dass** in der der Schwenkachse (226) zum Verschwenken des Designdeckels (280) abgekehrten Seitenwand (230a; 221 a) des Designdeckels (280) oder des Grundgehäuses (221) durch quer zur Seitenwandlängsrichtung verlaufende Schlitze (232, 233) von der übrigen Seitenwandfläche getrennt mindestens ein federnder, zungenförmiger Seitenwandabschnitt (235) ausgebildet ist, der fedemd-elastisch ist und ein Rückstellvermögen aufgrund des Materials, aus dem der Designdeckel (280) besteht, aufweist, wobei der zungenförmige Seitenwandabschnitt (235) vermittels eines Steges (238) in der Seitenwand (230a) gehalten ist und im Bereich seines freien Endes zur Herstellung einer lösbaren Rastverbindung (240) zwischen dem Designdeckel (280) und dem Grundgehäuse (221) ein Eingriffelement (296) aufweist, das mit einem Halteelement (297) in Wirkverbindung bringbar ist, das an der Seitenwand (221a) des Grundgehäuses (221) vorgesehen ist, die mit der Seitenwand (230a) des Designdeckels (280) korrespondiert.

4. Luftdurchtrittsvorrichtung nach Anspruch 1 oder 2,
**dadurch gekennzeichnet,**
**dass** das oberste Lamellenelement (90') des Lüftergitters um seine Längsachse (LA) verschwenkbar an den Seitenwänden (30b, 30d) des Designdeckels (80) gehalten ist.

5. Luftdurchtrittsvorrichtung nach einem der vorangehenden Ansprüche 1, 2 und 4
**dadurch gekennzeichnet,**
**dass** ein Abschnitt (90'a) des obersten Lamellenelementes (90') des Lüftergitters (10) in dem Lamellenelement (90') um eine in Längsrichtung des Lamellenelementes (90') verlaufende Drehachse (DA) verschwenkbar ausgebildet ist.

6. Luftdurchtrittvorrichtung nach Anspruch 1 oder 2,
**dadurch gekennzeichnet,**
**dass** in der die dem obersten Lamellenelement (90') des Lüftergitters (10) zugekehrten Seitenwand (30a) durch quer zur Seitenwandlängsrichtung verlaufende Schlitze (32, 33) ein Seitenwandabschnitt (35) ausgebildet ist, an dem mit seiner Längskante ein in den sich gegenüberliegenden Seitenwänden (30b, 30d) des Designdeckels (80) unverbundenes Lamellenelement (90") angeformt ist, wobei im Bereich der Anformung des Lamellenelementes (90") an dem Seitenwandabschnitt (35) der Seitenwand (30a) des Designdeckels (80) die Längsachse (LA) für das Verschwenken des Seitenwandabschnittes (35) bei Fingerbetätigung des Lamellenelementes (90") liegt.

7. Luftdurchtrittsvorrichtung nach einem der vorangehenden Ansprüche 1, 2, 4 bis 6,
**dadurch gekennzeichnet,**
**dass** das oberste Lamellenelement (90, 90') oder ein Lamellenelementabschnitt im Bereich seiner dem Grundgehäuse (21) zugekehrten und der bodenseitigen Schwenkachse (26) des Lüftergitters (10) abgekehrten Längskante (90a) mindestens einen Rastnocken (96) aufweist, der zur Ausbildung einer Rastverbindung in Wirkverbindung mit mindestens einem hakenförmigen oder ausnehmungsartigen Rastelement (97) in Wirkverbindung bringbar ist.

8. Luftdurchtrittsvorrichtung nach einem der vorangehenden Ansprüche 1, 2, 4 bis 6,
**dadurch gekennzeichnet,**
**dass** der verschwenkbare Seitenwandabschnitt (35) der Seitenwand (30a) des Designdeckels (80) mindestens einen Rastnocken (96) aufweist, der zur Ausbildung einer Rastverbindung in Wirkverbindung mit mindestens einem hakenförmigen oder ausnehmungsartigen Rastelement (97) in Wirkverbindung bringbar ist.

9. Luftdurchtrittsvorrichtung nach Anspruch 1 oder 3,
**dadurch gekennzeichnet,**
**dass** zur Herstellung der lösbaren Rastverbindung (240) zwischen dem Designdeckel (280) und dem Grundgehäuse (221) mindestens eine der Seitenwände (230a, 230b, 230c, 230d) des Rahmens (230) des Designdeckels (280) mindestens einen aus dem Material der Seitenwand (230a, 230b, 230c, 230d) ausgebildeten federnden, zungenförmigen Seitenwandabschnitt (235) aufweist, der einendseitig über einen Steg (238) mit der Seitenwand (230a, 230b, 230c, 230d) verbunden und in dieser gehalten ist und die an ihrem freien Ende einen Rastnocken (245) als Eingriffelement (296) aufweist, der mit dem Halteelement (297) in Wirkverbindung bringbar ist, das in der Seitenwand (221 a) des Grundgehäuses (221) vorgesehen ist, die mit der Seitenwand (230a) des Designdeckels (280) korrespondiert.

10. Luftdurchtrittsvorrichtung nach einem der vorangehenden Ansprüche 1, 3 und 9,
**dadurch gekennzeichnet,**
**dass** der federnde, zungenförmige Seitenwandabschnitt (235) durch zwei quer zur Längsrichtung der Seitenwand (230a) des Rahmens (230) des Designdeckels (280) verlaufende Längsschlitze (232, 233) ausgebildet ist, deren Länge kleiner ist als die Breite der Seitenwand (230a).

11. Luftdurchtrittsvorrichtung nach einem der vorangehenden Ansprüche 1, 3, 9 und 10,
**dadurch gekennzeichnet,**
**dass** die federnd-elastischen Eigenschaften des zungenförmigen Seitenwandabschnittes (235) durch die Materialeigenschaften des Designdeckels (280) gegeben sind.

12. Luftdurchtrittsvorrichtung nach einem der vorangehenden Ansprüche 1, 3, 9 bis 11,
**dadurch gekennzeichnet,**
**dass** in den oberen Bereichen bzw. in den Seitenwänden (230a, 221a) des Designdeckels (280) und/oder des Grundgehäuses (221) mindestens ein zungenförmiger Seitenwandabschnitt (235) und mindestens ein mit dem zungenförmigen Seitenwandabschnitt (235) korrespondierendes Halteelement (297) in den jeweiligen korrespondierenden Seitenwänden (230a, 221 a) der Rahmen (230, 321) des Designdeckels (280) und/oder des Grundgehäuses (221) vorgesehen sind.

13. Luftdurchtrittsvorrichtung nach einem der vorangehenden Ansprüche 1, 3, 9 bis 12,
**dadurch gekennzeichnet,**
**dass** der zungenförmige Seitenwandabschnitt (235) mit seinem Eingriffelement (296) und das mit diesem korrespondierende Halteelement (297) mittig an den Seitenwänden (230a, 221 a) der Rahmen (230, 321) des Designdeckels (280) und des Grundgehäuses (221) angeordnet sind.

14. Luftdurchtrittsvorrichtung nach einem der vorangehenden Ansprüche 1, 3, 9 bis 12,
**dadurch gekennzeichnet,**
**dass** in den oberen Bereichen bzw. in den miteinander korrespondierenden Seitenwänden (230a, 221a) des Designdeckels (280) und des Grundgehäuses (221) zwei zungenförmige Seitenwandabschnitte (235) und zwei mit den zungenförmigen Seitenwandabschnitten (235) korrespondierende Halteelemente (297) vorgesehen sind.

15. Luftdurchtrittsvorrichtung nach einem der vorangehenden Ansprüche 1, 3, 9 bis 14,
**dadurch gekennzeichnet,**
**dass** jeder zungenförmige Seitenwandabschnitt (235) an seinem freien Ende einen im rechten Winkel abgebogenen Abschnitt (245') aufweist, der in eine entsprechend ausgebildete schlitzförmige Ausnehmung oder Durchbrechung (239') in der mit der Seitenwand (230a) des Designdeckels (280) korrespondierenden Seitenwand (221a) des Rahmens (321) des Grundgehäuses (221) als Halteelement (297) eingreift bzw. hintergreift.

16. Luftdurchtrittsvorrichtung nach einem der vorangehenden Ansprüche 1, 3, 9 bis 14,
**dadurch gekennzeichnet,**
**dass** jeder zungenförmige Seitenwandabschnitt (235) des Designdeckels (280) im Bereich seines freien Endes einen Rastnocken (245) aufweist, wobei an der Unterseite der die Seitenwand (230a) des Designdeckels (280) übergreifenden Seitenwand (221a) des Grundgehäuses (221) eine entsprechend der Formgebung des Rastnockens (245) entsprechend gestaltete Vertiefung (239) oder Durchbrechung, Bohrung oder Sacklochbohrung vorgesehen ist.

17. Luftdurchtrittsvorrichtung nach einem der vorangehenden Ansprüche 1, 3, 9 bis 16,
**dadurch gekennzeichnet,**
**dass** der Designdeckel (280) und das Grundgehäuse (221) aus Kunststoff oder einem Metall, insbesondere mit federnd-elastischen Eigenschaften, bestehen.

18. Luftdurchtrittsvorrichtung nach einem der vorangehenden Ansprüche 1, 3, 9 bis 17,
**dadurch gekennzeichnet,**
**dass** in der Seitenwand (221a) des Rahmens (321) des Grundgehäuses (221) im Bereich des zungenförmigen Seitenwandabschnittes (235) in der mit der Seitenwand (221a) des Grundgehäuses (221) korrespondierende Seitenwand (230a) des Designdeckels (280) eine Durchbohrung oder Durchbrechung (330) vorgesehen ist.

19. Luftdurchtrittsvorrichtung nach einem der vorangehenden Ansprüche 1, 3, 9 bis 18,
**dadurch gekennzeichnet,**
**dass** der Designdeckel (280) an jeder beliebigen Seitenwand (221a, 221b, 221c, 221d) des Rahmens (321) des Grundgehäuses (221) verschwenkbar angeordnet ist, wobei die Rastnocken (240) für den Designdeckel (280) und dem Grundgehäuse (221) an dem der Schwenkachse für den Designdeckel (280) gegenüberüegenden Seitenwänden des Designdeckels (280) und dem Grundgehäuse (221) vorgesehen ist.

20. Luftdurchtrittsvorrichtung nach einem der vorangehenden Ansprüche 1, 3, 9 bis 19,
**dadurch gekennzeichnet,**
**dass** zur Herstellung der lösbaren Rastverbindung (240) zwischen dem Designdeckel (280) und dem Grundgehäuses (221) in mindestens einer der Seitenwände (221 a, 221 b, 221 c, 221 d) des Rahmens (321) des Grundgehäuses (221) mindestens ein aus dem Material der Seitenwand durch quer zur Seitenwandlängsrichtung verlaufende Schlitze (232, 233) von der übrigen Seitenwandfläche getrennter federnder zungenförmiger Seitenwandabschnitt (235) ausgebildet ist, wobei der zungenförmige Seitenwandabschnitt (235) vermittels eines Steges (238) in der Seitenwand (221 a) gehalten ist und innenwandseitig ein Halteelement (297) in Form einer bevorzugter Weise kreisrunden Vertiefung (239) oder Durchbrechung, Bohrung oder Sacklochbohrung aufweist, die mit einem Eingriffelement (296) in Form eines Rastnockens (245) in Wirkverbindung bringbar ist, das an der mit der das Halteelement (297) aufweisenden Seitenwand (221a) des Grundgehäuses (221) korrespondierenden Seitenwand (230a) des Designdeckels (280) angeordnet oder angeformt ist, wobei der Rastnocken (245) bevorzugter Weise an seinem freien Ende mit einem abschnittsweise ausgebildeten oder umlaufenden konisch zum Rastnockenende (245b) verlaufenden Abschnitt (245a) als Gleitfläche versehen ist.

21. Luftdurchtrittsvorrichtung nach Anspruch 20,
**dadurch gekennzeichnet,**
**dass** bei einer Rastverbindung (240) mit je einem Halteelement (297) und einem Eingriffelement (296) diese mittig in den Seitenwänden (221a, 230a) des Grundgehäuses (221) und des Designdeckels (280) angeordnet sind.

## Claims

1. An air passing device, in particular a filter fan or an outlet fan for mounting into an assembly through hole (50) in a wall (51), in particular of a housing for components, which generate waste heat, such as control cabinet, electronic cubicle, computer system or the like, wherein the air passing device (200) comprises a basic housing (21; 221) said housing having a circumferential frame (321) having side walls (21a, 21b, 21c, 21d; 221a, 221b, 221c, 221d), and a design cover (80; 280) said design cover (80) having a circumferential frame (30; 230) having side walls (30a, 30b, 30c, 30d; 230a, 230b, 230c, 230d), which is integrally molded on the design cover (80) on the side of the air outlet, said frame (30; 230) engaging with its side walls into the side walls of the frame (321) of the basic housing (21; 221) and accommodating a filter pad (60), wherein the design cover (80; 280) encompasses, at the side of the air inlet, a cover device (100), which is embodied as an air inlet grill (10; 210) preferably comprising lamellar elements (90, 90'; 290, 290'), which are held at two side walls of the design cover (80; 280) located opposite one another, and wherein the design cover (80; 280) is arranged at the basic housing (21; 221) about a horizontal or vertical pivot axis (26; 226) for releasing a removal opening (29) for removing or inserting, respectively, the filter pad (60) for the purpose of changing the filter pad,
**characterized in**
**that** at least one pivotable lamellar element (90) or, through slits (332, 333) running transversely to the longitudinal side wall surface direction separated from the remaining side wall, at least one resilient, tongue-shaped side wall section (235) is embodied in the area of the upper side wall of the design cover facing away from the pivot axis (26; 226) for pivoting the design cover (80; 280) or in the upper side wall (221a) of the frame (321) of the basic housing (221), wherein the lamellar element (90) and the tongue-shaped side wall section (235) are embodied as a finger-activatable, releasable and lockable locking connection (40; 240) between the design cover (80; 280) and the basic housing (21; 221).

2. The air passing device according to claim 1,
**characterized in**
**that** at least one lamellar element (90), preferably the uppermost lamellar element (90') or a section of the lamellar element (90') or a lamellar element (90") of the fan grill, which is only connected to the upper side wall (30a) of the design cover (80) with its longitudinal edge, is arranged in the fan grill (10) so as to be capable of being pivoted about an axis of rotation (DA), which runs in longitudinal direction of the lamellar element and is embodied as a finger-activatable activating element (95) for an interlocking device (40) for locking and releasing a lock between the fan grill (10) and the basic housing (21).

3. The air passing device according to claim 1,
**characterized in**
**that** at least one resilient, tongue-shaped side wall section (235) is embodied in the side wall (230a; 221 a) of the design cover (280) or of the basic housing (221) facing away from the pivot axis (226) for pivoting the design cover (280) through slits (232, 233) running at right angles to the longitudinal side wall direction separated from the remaining side wall surface, said side wall section (235) being spring-elastic and encompassing a resilience due to the material from which the design cover (280) is made, wherein the tongue-shaped side wall section (235) is held in the side wall (230a) by means of a bar (238) and encompasses, in the area of its free end, for establishing a releasable locking connection (240) between the design cover (280) and the basic housing (221), an engagement element (296), which can be brought into an operative connection with a holding element (297), which is provided on the side wall (221 a) of the basic housing (221), which corresponds to the side wall (230a) of the design cover (280).

4. The air passing device according to claim 1 or 2,
**characterized in**
**that** the uppermost lamellar element (90') of the fan grill is held on the side walls (30b, 30d) of the design cover (80) so as to be pivotable about its longitudinal axis (LA).

5. The air passing device according to one of the preceding claims 1, 2 and 4,
**characterized in**
**that** a section (90'a) of the uppermost lamellar element (90') of the fan grill (10) in the lamellar element (90') is embodied so as to be pivotable about an axis of rotation (DA), which runs in longitudinal direction of the lamellar element (90').

6. The air passing device according to claim 1 or 2,
**characterized in**
**that** a side wall section (35) is embodied in the side wall (30a) facing towards the uppermost lamellar element (90') of the fan grill (10) through slits (32, 33) running at right angles to the longitudinal side wall direction, to which side wall section (35) a lamellar element (90"), which is not connected in the side walls (30b, 30d) of the design cover (80) located opposite one another, is integrally molded with its longitudinal edge, wherein the longitudinal axis (LA) for pivoting the side wall section (35) in response to a finger activation of the lamellar element (90") is located in the area of the formation of the lamellar element (90") at the side wall section (35) of the side wall (30a) of the design cover (80).

7. The air passing device according to one of the preceding claims 1, 2, 4 to 6,
**characterized in**
**that**, in the area of its longitudinal edge (90a), which faces the basic housing (21) and which faces away from the pivot axis (26) of the fan grill at the bottom side, the uppermost lamellar element (90, 90') or a lamellar element section encompasses at least one locking cam (96), which can be brought into an operative connecting with at least one hook-shaped or recess-like locking element (97) for forming a locking connection in operative connection.

8. The air passing device according to one of the preceding claims 1, 2, 4 to 6,
**characterized in**
**that** the pivotable side wall section (35) of the side wall (30a) of the design cover (80) encompasses at least one locking cam (96), which can be brought into an operative connecting with at least one hook-shaped or recess-like locking element (97) for forming a locking connection in operative connection.

9. The air passing device according to claim 1 or 3,
**characterized in**
**that,** for establishing the releasable locking connection (240) between the design cover (280) and the basic housing (221), at least one of the side walls (230a, 230b, 230c, 230d) of the frame (230) of the design cover (280) encompasses at least one resilient, tongue-shaped side wall section (235), which is embodied from the material of the side wall (230a, 230b, 230c, 230d) and which is connected to the side wall (230a, 230b, 230c, 230d) on the side of one end via a bar (238) and is held therein and which encompasses on its free end a locking cam (245) as engagement element (296), which can be brought into an operative connection with the holding element (297), which is provided in the side wall (221 a) of the basic housing (221), which corresponds to the side wall (230a) of the design cover (280).

10. The air passing device according to one of the preceding claims 1, 3 and 9,
**characterized in**
**that** the resilient, tongue-shaped side wall section (235) is embodied by means of two longitudinal slits (232, 233), which run at right angles to the longitudinal direction of the side wall (230a) of the frame (230) of the design cover (280), the length of said longitudinal slits (232, 233) being smaller than the width of the side wall (230a).

11. The air passing device according to one of the preceding claims 1, 3, 9 and 10,
**characterized in**
**that** the spring-elastic characteristics of the tongue-shaped side wall section (235) are given by means of the material characteristics of the design cover (280).

12. The air passing device according to one of the preceding claims 1, 3, 9 to 11,
**characterized in**
**that** provision is made in the upper areas or in the side walls (230a, 221a) of the design cover (280), respectively, and/or of the basic housing (221), for at least one tongue-shaped side wall section (235) and for at least one holding element (297), which corresponds to the tongue-shaped side wall section (235), in the respective corresponding side walls (230a, 221 a) of the frame (230, 321) of the design cover (280) and/or of the basic housing (221).

13. The air passing device according to one of the preceding claims 1, 3, 9 to 12,
**characterized in**
**that** the tongue-shaped side wall section (235) with its engagement elements (296) and the holding element (297) corresponding thereto, are arranged centrally at the side walls (230a, 221 a) of the frame (230, 321) of the design cover (280) and of the basic housing (221).

14. The air passing device according to one of the preceding claims 1, 3, 9 to 12,
**characterized in**
**that** provision is made in the upper areas or in the side walls (230a, 221 a) of the design cover (280) and of the basic housing (221), which correspond to one another, respectively, for two tongue-shaped side wall sections (235) and for two holding elements (297), which correspond to the tongue-shaped side wall sections (235).

15. The air passing device according to one of the preceding claims 1, 3, 9 to 14,
**characterized in**
**that** each tongue-shaped side wall section (235) encompasses on its fee end a section (245'), which is bent off at a right angle, which engages with or engages behind, respectively, a correspondingly embodied slit-shaped recess or through hole (239') in the side wall (221 a) of the frame (321) of the basic housing (221), which corresponds to the side wall (230a) of the design cover (280), as a holding element (297).

16. The air passing device according to one of the preceding claims 1, 3, 9 to 14,
**characterized in**
**that** each tongue-shaped side wall section (235) of the design cover (280) encompasses a locking cam (245) in the area of its free end, wherein provision is made on the lower side of the side wall (221 a) of the basic housing (221), which overlaps the side wall (230a) of the design cover (280), for a depression (239) or through hole, bore or blind hole, which is configured according to the design of the locking cam (245).

17. The air passing device according to one of the preceding claims 1, 3, 9 to 16,
**characterized in**
**that** the design cover (280) and the basic housing (221) consist of plastic or a metal, in particular comprising spring-elastic characteristics.

18. The air passing device according to one of the preceding claims 1, 3, 9 to 17,
**characterized in**
**that** provision is made in the side wall (221 a) of the frame (321) of the basic housing (221) in the area of the tongue-shaped side wall section (235) in the side wall (230a) of the design cover (280), which corresponds to the side wall (221 a) of the basic housing (221), for a perforation or through hole (330).

19. The air passing device according to one of the preceding claims 1, 3, 9 to 18,
**characterized in**
**that** the design cover (280) is arranged on each arbitrary side wall (221 a, 221 b, 221 c, 221 d) of the frame (321) of the basic housing (221) so as to be capable of being pivoted, wherein provision is made on the side walls of the design cover (280) and the basic housing (221) for the locking cams (240) for the design cover (280) and the basic housing (221), which are located opposite to the pivot axis for the design cover (280).

20. The air passing device according to one of the preceding claims 1, 3, 9 to 19,
**characterized in**
**that,** to establish the releasable locking connection (240) between the design cover (280) and the basic housing (221), at least one resilient, tongue-shaped side wall section (235), which is separated from the remaining side wall surface and made of the material of the side wall through slits (232, 233) running at right angles to the longitudinal side wall direction, is embodied in at least one of the side walls (221 a, 221 b, 221 c, 221 d) of the frame (321) of the basic housing (221), wherein the tongue-shaped side wall section (235) is held in the side wall (221 a) by means of a bar (238) and encompasses, on the side of the inner wall, a holding element (297) in the form of a preferably circular depression (239) or through hole, bore or blind hole, which can be brought into operative connection with an engagement element (296) in the form of a locking cam (245), which is arranged or integrally molded on the side wall (230a) of the design cover (280), which corresponds to the side wall (221 a) of the basic housing (221), which encompasses the holding element (297), wherein the locking cam (245) is preferably provided with a section (245a) as sliding surface, which is embodied section by section or in a revolvingly conical manner to the end of the locking cam (245b), preferably at its free end.

21. The air passing device according to claim 20,
**characterized in**
**that** in a locking connection (240) comprising in each case one holding element (297) and one engagement element (296), they are arranged centrally in the side walls (221a, 230a) of the basic housing (221) and of the design cover (280).

## Revendications

1. Dispositif de passage d'air, notamment ventilateur à filtre ou filtre de sortie, à monter dans une perforation de montage (50) dans une paroi (51), notamment d'un logement pour composants générant des rejets thermiques, comme des armoires de commande, baies électroniques, systèmes informatiques ou similaire, dans lequel le dispositif de passage d'air (200) comprend un logement de base (21 ;221) avec un châssis (321) périphérique constitué de parois latérales (21a, 21b, 21c, 21 d ; 221a, 221b, 221 c, 221d) et un couvercle design (80 ;280) comportant un châssis (30 ;230) périphérique, façonné du côté de sortie de l'air constitué de parois latérales (30a, 30b, 30c, 30d ; 230a, 230b, 230c, 230d), qui vient en prise par ses parois latérales dans les parois latérales du châssis (321) du logement de base (21 ;221) et renferme un matelas de filtrage (60), dans lequel le couvercle design ( 80 ;280) présente du côté d'entrée de l'air un dispositif de recouvrement (100) configuré comme grille de ventilation (10 ;210) avec des éléments de lamelle (90,90' ; 290,290')maintenus de manière préférée sur deux parois latérales opposées du couvercle design (80 ;280) et dans lequel le couvercle design (80 ;280) est disposé sur le logement de base (21 ;221) autour d'un axe de pivotement (26 ;226) horizontal ou perpendiculaire afin de découvrir une ouverture de retrait (29) pour le retrait, respectivement l'introduction du matelas de filtrage (60) à des fins de remplacement d'un matelas de filtrage,
**caractérisé en ce que**
au moins un élément de lamelle basculant (90) ou, séparée du reste de la surface de paroi latérale par une fente (332,333) s'étendant transversalement à la direction longitudinale de paroi latérale, au moins une portion de paroi latérale (235) en forme de languette, faisant ressort est réalisé au niveau de la paroi latérale supérieure du couvercle design (80 ;280), éloignée de l'axe de pivotement (26 ;226) pour basculer le couvercle design (80 ;280) ou de la paroi latérale supérieure (221 a) du châssis (321) du logement de base (221), dans lequel l'élément de lamelle (90) et la portion de paroi latérale en forme de languette (235) sont configurés comme une liaison par encliquetage (40 ;240) actionnable au doigt, amovible et verrouillable entre le couvercle design (80 ;280) et le logement de base (21 ;221).

2. Dispositif de passage d'air selon la revendication 1,
**caractérisé en ce que**
au moins un élément de lamelle (90), de manière préférée l'élément de lamelle (90') le plus haut, ou une portion de l'élément de lamelle (90') ou un élément de lamelle (90") de la grille de ventilateur (10) seulement relié à la paroi latérale supérieure (30a) du couvercle design (80) par son arête longitudinale est disposé de manière à basculer autour d'un axe de rotation (DA) s'étendant dans la direction longitudinale de l'élément de lamelle dans la grille de ventilateur (10) et est configuré comme un élément d'actionnement (95) actionnable au doigt pour un dispositif d'arrêt (40) afin de verrouiller et déverrouiller un verrouillage entre la grille de ventilateur (10) et le logement de base (21).

3. Dispositif de passage d'air selon la revendication 1,
**caractérisé en ce que**
au moins une portion de paroi latérale (235) en forme de languette, faisant ressort est réalisée dans la paroi latérale (230a ;221 a)éloignée de l'axe de pivotement (226) pour basculer le couvercle design (280) du couvercle design (280) ou du logement de base (221), séparée du reste de la surface de paroi latérale par une fente (232,233) s'étendant transversalement à la direction longitudinale de paroi latérale, laquelle est élastique/faisant ressort et présente une faculté de rappel élastique en raison du matériau, dont le couvercle design (280) est constitué, dans lequel la portion de paroi latérale (235) en forme de languette est maintenue dans la paroi latérale (230a) au moyen d'un gradin (238) et présente un élément de mise en prise (296) au niveau de son extrémité libre afin d'établir une liaison par encliquetage (240) amovible entre le couvercle design (280) et le logement de base (221), lequel peut être amené en liaison opérationnelle avec un élément de retenue (297), qui est prévu sur la paroi latérale (221a) du logement de base (221), laquelle correspond à la paroi latérale (230a) du couvercle design (280).

4. Dispositif de passage d'air selon la revendication 1 ou 2,
**caractérisé en ce que**
l'élément de lamelle (90') le plus haut de la grille de ventilateur est maintenu autour de son axe longitudinal (LA) de manière à basculer sur les parois latérales (30b,30d) du couvercle design (80).

5. Dispositif de passage d'air selon une des revendications précédentes 1,2 et 4,
**caractérisé en ce que**
une portion (90'a) de l'élément de lamelle le plus haut (90')de la grille de ventilateur est configurée dans l'élément de lamelle (90') de manière à basculer autour d'un axe de rotation (DA) s'étendant dans la direction longitudinale de l'élément de lamelle (90').

6. Dispositif de passage d'air selon la revendication 14 ou 2,
**caractérisé en ce que**
dans la paroi latérale (30a) tournée vers l'élément de lamelle le plus haut (90') de la grille de ventilateur (10), une portion de paroi latérale (35) est réalisée par une fente (32,33) s'étendant transversalement à la direction longitudinale de paroi latérale, sur laquelle par son arête longitudinale un élément de lamelle (90") non relié aux parois latérales (30b,30d) se faisant face du couvercle design (80) est façonné, dans lequel au niveau du façonnage de l'élément de lamelle (90") sur la portion de paroi latérale (35) de la paroi latérale (30a) du couvercle design (80) l'axe longitudinal (LA) en vue du basculement de la portion de paroi longitudinale (35) par actionnement au doigt de l'élément de lamelle (90") est situé.

7. Dispositif de passage d'air selon une des revendications précédentes 1,2,4 à 6,
**caractérisé en ce que**
l'élément de lamelle le plus haut (90,90') ou une portion d'élément de lamelle au niveau de son arête longitudinale (90a) tournée vers le logement de base (21) et éloignée de l'axe de pivotement (26) du côté de la base de la grille de ventilateur (10) présente au moins une came d'encliquetage (96), laquelle peut être amenée en liaison opérationnelle avec au moins un élément d'encliquetage (97) en forme de crochet ou du type évidement afin de réaliser une liaison par encliquetage.

8. Dispositif de passage d'air selon une des revendications précédentes 1,2,4 à 6,
**caractérisé en ce que**
la portion de paroi latérale (35) basculante de la paroi latérale (30a) du couvercle design (80) présente au moins une came d'encliquetage (96), laquelle peut être amenée en liaison opérationnelle avec au moins un élément d'encliquetage (97) en forme de crochet ou du type évidement afin de réaliser une liaison par encliquetage.

9. Dispositif de passage d'air selon la revendication 1 ou 3,
**caractérisé en ce que**
pour établir la liaison par encliquetage amovible (240) entre le couvercle design (280) et le logement de base (221), au moins une des parois latérales (230a, 230b, 230c, 230d) du châssis (230) du couvercle design (280) présente au moins une portion de paroi latérale (235) en forme de languette, faisant ressort réalisée dans le matériau de la paroi latérale (230a, 230b, 230c, 230d), laquelle est reliée à une extrémité par l'intermédiaire d'un gradin (238) à la paroi latérale (230a, 230b, 230c, 230d) et est maintenu dans celle-ci et laquelle présente à son extrémité libre une came d'encliquetage (245) en tant qu'élément de mise en prise (296), qui peut être amené en liaison opérationnelle avec l'élément de retenue (297), lequel est prévu dans la paroi latérale (221 a) du logement de base (221), qui correspond à la paroi latérale (230a) du couvercle design (280).

10. Dispositif de passage d'air selon une des revendications précédentes 1,3 et 9,
**caractérisé en ce que**
la portion de paroi latérale (235) en forme de languette, faisant ressort est réalisée par deux fentes longitudinales (232,233) s'étendant transversalement à la direction longitudinale de la paroi latérale (230a) du châssis (230) du couvercle design (280), dont la longueur est plus petite que la largeur de la paroi latérale (230a).

11. Dispositif de passage d'air selon une des revendications précédentes 1,3,9 et 10,
**caractérisé en ce que**
les propriétés élastiques/faisant ressort de la portion de paroi latérale (235) en forme de languette sont induites par les propriétés de matériau du couvercle design (280).

12. Dispositif de passage d'air selon une des revendications précédentes 1,3,9 à 11,
**caractérisé en ce que**
dans les zones supérieures, respectivement dans les parois latérales (230a, 221 a) du couvercle design (280) et/ou du logement de base (221), au moins une portion de paroi latérale (235) en forme de languette et au moins un élément de retenue (297) correspondant à la portion de paroi latérale (235) en forme de languette sont prévues dans les parois latérales (230a, 221 a) correspondantes respectives du châssis (230, 321) du couvercle design (280) et/ou du logement de base (221).

13. Dispositif de passage d'air selon une des revendications précédentes 1,3,9 à 12,
**caractérisé en ce que**
la portion de paroi latérale (235) en forme de languette avec son élément de mise en prise (296) et l'élément de retenue (297) correspondant à celui-ci sont disposés au centre sur les parois latérales (230a,221a) du châssis (230,321) du couvercle design (280) et du logement de base (221).

14. Dispositif de passage d'air selon une des revendications précédentes, 1,3,9 à 12,
**caractérisé en ce que**
dans les zones supérieures, respectivement dans les parois latérales (230a, 221 a) correspondant les unes aux autres du couvercle design (280) et du logement de base (221), deux portions de parois latérales (235) en forme de languette et deux éléments de retenue (297) correspondant aux portions de parois latérales (235) en forme de languette sont prévues.

15. Dispositif de passage d'air selon une des revendications précédentes 1,3,9 à 14,
**caractérisé en ce que**
chaque portion de paroi latérale (235) en forme de languette présente à son extrémité libre une portion (245') coudée à angle droit, laquelle vient en prise, respectivement vient en prise par derrière avec un évidement ou une perforation (239') en forme de fente correspondante dans la paroi latérale (221 a) du châssis (321) du logement de base (221)correspondant à la paroi latérale (230a) du couvercle design (280) en tant qu'élément de retenue (297).

16. Dispositif de passage d'air selon une des revendications précédentes 1,3,9 à 14,
**caractérisé en ce que**
chaque portion de paroi latérale en forme de languette (235) du couvercle design (280) présente au niveau de son extrémité libre une came d'encliquetage (245), dans lequel sur le côté inférieur de la paroi latérale (221a) du logement de base (221) s'engageant pardessus la paroi latérale (230a) du couvercle design (280), un renfoncement (239) ou une perforation, un alésage ou un trou borgne conçu de manière à correspondre à la forme initiale de la came d'encliquetage (245à) est prévu.

17. Dispositif de passage d'air selon une des revendications précédentes 1,3,9 à 16,
**caractérisé en ce que**
le couvercle design (280) et le logement de base (221) sont constitués de plastique ou d'un métal, notamment avec des propriétés élastiques/ faisant ressort.

18. Dispositif de passage d'air selon une des revendications précédentes 1,3,9 à 17,
**caractérisé en ce que**
dans la paroi latérale (221 a) du châssis (321) du logement de base (221) au niveau de la portion de paroi latérale (235) en forme de languette dans la paroi latérale (230a) du couvercle design (280) correspondant à la paroi latérale (221 a) du logement de base (221), un alésage traversant ou une perforation traversante (330) sont prévus.

19. Dispositif de passage d'air selon une des revendications précédentes 1,3,9 à 18,
**caractérisé en ce que**
le couvercle design (280) est disposé sur chaque paroi latérale au choix (221a, 221 b, 221c, 221d) du châssis (321) du logement de base (221) de manière basculante, dans lequel la came d'encliquetage (240) destinée au couvercle design (280) est prévue sur les parois latérales du couvercle design (280) et du logement de base (221) faisant face à l'axe de pivotement du couvercle design (280).

20. Dispositif de passage d'air selon une des revendications précédentes 1,3,9 à 19,
**caractérisé en ce que**
pour établir la liaison par encliquetage amovible (240) entre le couvercle design (280) et le logement de base (221) dans au moins une des parois latérales (221a, 221 b, 221 c, 221 d) du châssis (321) du logement de base (221), au moins une portion de paroi latérale (235) en forme de languette faisant ressort, séparée du reste de la surface de paroi latérale par une fente (232,233) s'étendant transversalement à la direction longitudinale de paroi latérale , constituée du matériau de la paroi latérale est réalisée, dans lequel la portion de paroi latérale (235) en forme de languette est maintenue au moyen d'un gradin (238) dans la paroi latérale (221a) et du côté de la paroi intérieure présente un élément de retenue (297) sous forme d'un renforcement (239)ou d'une perforation, un alésage ou un trou borgne de préférence de forme arrondie circulaire, qui peut être amené en liaison opérationnelle avec un élément de mise en prise (296) sous forme d'une came d'encliquetage (245), laquelle est disposée ou façonnée sur la paroi latérale (230a) du couvercle design (280) correspondant à la paroi latérale (221 a) du logement de base (221) présentant l'élément de retenue (297), dans lequel la came d'encliquetage (245) est pourvue de préférence à son extrémité libre d'une portion (245a) réalisée ou s'étendant sur des portions coniquement en faisant le tour jusqu'à l'extrémité de came d'encliquetage (245b) en tant que surface de glissement.

21. Dispositif de passage d'air selon la revendication 20,
**caractérisé en ce que**
dans le cadre d'une liaison par encliquetage (240) avec respectivement un élément de retenue (297) et un élément de mise en prise (296), ceux-ci sont disposés au centre dans les parois latérales (221 a, 230a) du logement de base (221) et du couvercle design (280).
